# EUROPEAN PATENT APPLICATION

(11) **EP 3 872 867 A1**
(43) Date of publication of application: **01.09.2021**
(21) Application number: 21168622.5
(22) Date of filing: 21.08.2017
(51) Int. Cl.: H01L 31/00, G05D 1/00, H02S 20/00, A01D 34/00, H02S 40/38, H02S 50/00

(54) **AUTOMATIC WORKING SYSTEM**

(30) Priority: 19.08.2016 CN 201610693265
(62) Divisional of application: 17841135.1
(71) Applicant: Positec Power Tools (Suzhou) Co., Ltd, Suzhou, Jiangsu 215123 (CN)
(72) Inventor: HE, Mingming, Suzhou, 215123 (CN); TAN, Yiyun, Suzhou, 215123 (CN); LIU, Fangshi, Suzhou, 215123 (CN)
(74) Representative: Dentons UK and Middle East LLP

(57) **Abstract**

The present invention relates to an automatic working system, including: a self-moving device, configured to move and work in a working area, where the self-moving device includes a housing, a moving module, and a control module, and the control module controls the moving module to actuate the self-moving device to move; the self-moving device includes an energy consumption device, where the energy consumption device includes a device that consumes energy for actuating the self-moving device to move and work; and the self-moving device further includes: a photoelectric conversion unit, where the photoelectric conversion unit receives optical energy and converts the received optical energy into electric energy; and an energy storage unit, configured to store the electric energy obtained by conversion by the photoelectric conversion unit, where effective working electric energy that is received by the energy consumption device from the photoelectric conversion unit and that is converted by the photoelectric conversion unit is greater than or equal to energy consumed by the energy consumption device to actuate the self-moving device to move and work.

## Description

### BACKGROUND

### Technical Field

The present invention relates to an automatic working system, and particularly, to a solar-powered automatic working system.

### Related Art

Mowers are tools that help people maintain lawns. Recently, an increasing number of automatic mowers are launched. Automatic mowers can automatically mow and be charged in lawns of users and liberate users from boring and time- and labor-consuming housework for lawn maintenance, and therefore, are greatly welcomed. A charging manner of automatic mowers in the prior art is disposing a fixed charging station nearby a working area, and when an automatic mower has low battery power, enabling the automatic mower to automatically return to the charging station to be replenished with electric energy. A defect of such a manner is that an additional charging station is needed. It is troublesome to dispose the charging station since a user needs to connect a power cable to home. The charging station, as an accessory of the automatic mower, increases costs, and laying the charging station on a lawn affects appearance of the lawn. Another defect of such a manner is that each time the automatic mower needs to be charged, the automatic mower returns to the charging station, a program for controlling the automatic mower to return to the charging station and to be accurately docked with the charging station is complex, the automatic mower wears the lawn since it returns along a same path, and the automatic mower works after returning to the charging station to be fully charged each time, resulting in low work efficiency.

### SUMMARY

To overcome defects in the prior art, a problem that the present invention needs to resolve is to provide an automatic working system that does not need an additional charging station.

In the present invention, to resolve the problems in the prior art, the following technical solutions are used:
An automatic working system, comprising: a self-moving device, configured to move and work in a working area, wherein the self-moving device comprises a housing, a moving module, and a control module, and the control module controls the moving module to actuate the self-moving device to move;the self-moving device comprises an energy consumption device, wherein the energy consumption device comprises a device that consumes energy for actuating the self-moving device to move and work; and the self-moving device further comprises:a photoelectric conversion unit, wherein the photoelectric conversion unit receives optical energy and converts the received optical energy into electric energy; and an energy storage unit, configured to store the electric energy obtained by conversion by the photoelectric conversion unit, wherein effective working electric energy that is received by the energy consumption device from the photoelectric conversion unit and that is converted by the photoelectric conversion unit is greater than or equal to energy consumed by the energy consumption device to actuate the self-moving device to move and work.

In one embodiment, photoelectric conversion efficiency of the photoelectric conversion unit is greater than or equal to 0.12.

In one embodiment, the photoelectric conversion unit comprises monocrystalline silicon or polycrystalline silicon.

In one embodiment, the self-moving device comprises a charging panel for mounting the photoelectric conversion unit, disposed on the housing, wherein density of the charging panel is less than or equal to 10 kg/m².

In one embodiment, the self-moving device comprises a charging panel for mounting the photoelectric conversion unit, disposed on the housing, the charging panel comprises a protection layer covering a surface of the photoelectric conversion unit, and the protection layer is made from an epoxy glue.

In one embodiment, an area of the photoelectric conversion unit is greater than or equal to a projected area of the housing of the self-moving device on a working plane.

In one embodiment, the self-moving device comprises a charging panel for mounting the photoelectric conversion unit, disposed on the housing, and the charging panel is formed with an outer contour fitting the housing.

In one embodiment, when a voltage of the energy storage unit is less than or equal to a first threshold voltage, the control module controls the self-moving device to stop working until the voltage of the energy storage unit is greater than or equal to a second threshold voltage, and the second threshold voltage is greater than or equal to the first threshold voltage.

In one embodiment, the photoelectric conversion unit has a maximum power point voltage, and the maximum power point voltage is an output voltage of the photoelectric conversion unit when a conversion power of the photoelectric conversion unit reaches a maximum; and a ratio of a difference between the first threshold voltage or the second threshold voltage and the maximum power point voltage to the maximum power point voltage is not greater than 0.2.

In one embodiment, the self-moving device comprises a charging management unit, and the charging management unit comprises a voltage converter; the photoelectric conversion unit has a maximum power point voltage, and the maximum power point voltage is an output voltage of the photoelectric conversion unit when a conversion power of the photoelectric conversion unit reaches a maximum; and the voltage converter is electrically connected between the photoelectric conversion unit and the energy storage unit, to enable the output voltage of the photoelectric conversion unit to be maintained at the maximum power point voltage.

In one embodiment, the self-moving device further comprises a positioning module, configured to output positioning information of the self-moving device.

In one embodiment, the control module receives positioning information at one or more locations of the self-moving device when the self-moving device moves in the working area, receives illumination intensity information at one or more locations of the self-moving device when the self-moving device moves in the working area, and generates an illumination map of the working area based on the received positioning information and illumination intensity information.

In one embodiment, the self-moving device comprises an illumination sensor, and the illumination intensity information received by the control module is output from the illumination sensor.

In one embodiment, the illumination intensity information received by the control module is obtained by estimating an output voltage of the photoelectric conversion unit.

In one embodiment, the positioning module receives a satellite positioning signal, and the illumination intensity information received by the control module is obtained by estimating intensity of the satellite positioning signal.

In one embodiment, the control module further receives attitude information at one or more locations of the self-moving device when the self-moving device moves in the working area, and the illumination map records the attitude information.

In one embodiment, the self-moving device comprises an attitude sensor, and the attitude information received by the control module is output from the attitude sensor.

In one embodiment, the control module records a time period of receiving the positioning information and the corresponding illumination intensity information, and generates the illumination map that is based on time.

In one embodiment, the control module estimates an illumination intensity level at one or more locations of the working area based on the received illumination intensity information; and the self-moving device comprises a charging mode, and when the self-moving device enters the charging mode, the control module controls the self-moving device to move, based on the illumination map, to a location at which illumination intensity satisfies a preset level to be replenished with electric energy.

In one embodiment, when the self-moving device enters the charging mode, a location at which illumination intensity satisfies the preset level and that is closest to a current location is determined, and the self-moving device is controlled to move to the location to be replenished with electric energy.

In one embodiment, when determining that a voltage of the energy storage unit is less than or equal to the first threshold voltage, the control module controls the self-moving device to enter the charging mode.

In one embodiment, when the self-moving device moves, the control module estimates a distance between a current location of the self-moving device and a location at which illumination intensity satisfies the preset level, and adjusts a value of the first threshold voltage based on the distance, wherein the value of the first threshold voltage increases as the distance increases.

In one embodiment, after the self-moving device exits the charging mode, the control module controls the self-moving device to return to an expected location, and the expected location comprises a location through which the self-moving device moves before the self-moving device enters the charging mode.

In one embodiment, when determining that the voltage of the energy storage unit is greater than or equal to a second threshold voltage, the control module controls the self-moving device to exit the charging mode.

In one embodiment, the self-moving device comprises an illumination intensity detection unit, configured to receive illumination intensity information, and the control module determines an illumination intensity level at a current location of the self-moving device based on the illumination intensity information received by the illumination intensity detection unit; and the self-moving device comprises a charging mode, and when the self-moving device enters the charging mode, the control module determines an illumination intensity level at a current location of the self-moving device, and controls the self-moving device to stay at or moves to a location at which illumination intensity satisfies a preset level to be replenished with electric energy.

In one embodiment, the illumination intensity detection unit comprises an illumination sensor, a photoelectric conversion unit output voltage detection module, or a satellite positioning signal receiving module.

In one embodiment, the self-moving device comprises a charging mode, and in the charging mode, the control module controls the self-moving device to change, at a location, an angle at which the photoelectric conversion unit receives optical energy, and the control module determines an optimal angle of the photoelectric conversion unit for receiving optical energy, and controls a receiving angle of the photoelectric conversion unit to be at least temporarily maintained at the optimal angle.

In one embodiment, in the charging mode, the control module controls the self-moving device to rotate, to actuate the photoelectric conversion unit to change an angle of receiving optical energy.

In one embodiment, the self-moving device includes a charging panel for mounting the photoelectric conversion unit, disposed on the housing; and in the charging mode, the charging panel rotates relative to the housing, to change an angle at which the photoelectric conversion unit receives optical energy.

In one embodiment, the control module receives illumination condition information of the working area, formulates or adjusts a working plan of the self-moving device based on the illumination condition information of the working area, and controls the self-moving device to carry out the working plan.

In one embodiment, the self-moving device comprises a communications module, configured to obtain weather information through the Internet; and the illumination condition information of the working area comprises the weather information, and the control module formulates or adjusts the working plan based on the weather information.

In one embodiment, the weather information comprises total low cloud amount information or illumination intensity information.

In one embodiment, the self-moving device comprises a clock module, configured to output a current moment; and the illumination condition information of the working area comprises time period information in one day, and the control module formulates or adjusts the working plan based on time period information of the current moment.

In one embodiment, the self-moving device comprises an illumination sensor, configured to output illumination intensity information currently received by the self-moving device; and the illumination condition information of the working area comprises the current illumination intensity information, and the control module formulates or adjusts the working plan based on the current illumination intensity information.

In one embodiment, the control module formulates or adjusts the working plan of the self-moving device according to a relationship between illumination intensity corresponding to the illumination condition information and a preset illumination intensity threshold.

In one embodiment, the working plan comprises enabling the self-moving device to enter a working mode, and in the working mode, the control module controls the self-moving device to move and work.

In one embodiment, when illumination intensity corresponding to the illumination condition information is less than or equal to a first illumination intensity threshold, and when a voltage of the energy storage unit is greater than a first threshold voltage, the control module controls the self-moving device to enter the working mode.

In one embodiment, when the illumination intensity corresponding to the illumination condition information is greater than the first illumination intensity threshold, and when the voltage of the energy storage unit is greater than or equal to a second threshold voltage, the control module controls the self-moving device to enter the working mode, wherein the second threshold voltage is greater than the first threshold voltage.

In one embodiment, when a voltage of the energy storage unit is less than or equal to a first threshold voltage, the self-moving device stops working; and the control module adjusts a value of the first threshold voltage based on the illumination condition information of the working area.

In one embodiment, the self-moving device comprises a storage unit, configured to store a season model parameter, and the season model parameter comprises illumination condition information of different regions and different time periods; and the control module receives a geographic location and date information, and obtains the season model parameter based on the received geographic location and date information, so as to determine illumination condition information of the working area in a current time period.

In one embodiment, a value of the first threshold voltage is increased as a time period in which illumination intensity reflected by the illumination condition information is maintained to be less than or equal to a first illumination intensity threshold is increased.

In one embodiment, the self-moving device comprises a storage unit, configured to store a preset path mode, and the control module controls the self-moving device to move in the preset path mode.

In one embodiment, a ratio of an area of a preset working area to an area of an area through which the self-moving device passes to complete coverage of the working area is referred as an effective coverage ratio of the self-moving device in the preset path mode; and the effective coverage ratio of the self-moving device in the preset path mode is greater than or equal to 0.6.

In one embodiment, the self-moving device comprises a temperature control device, configured to reduce a temperature of a periphery of the energy storage unit.

In one embodiment, the temperature control device comprises a container, configured to hold a cooling solvent and disposed in the periphery of the energy storage unit, to absorb heat of the energy storage unit; or the temperature control device comprises a fan, configured to form an airflow flowing from the energy storage unit to the outside of the housing; or the temperature control device comprises a heat insulation component, disposed in the periphery of the energy storage unit to insulate heat of the energy storage unit.

In one embodiment, the self-moving device comprises a charging panel for mounting the photoelectric conversion unit, disposed on the housing; and the control module generates or receives a cleaning request signal of the charging panel and generates a cleaning warning signal in response to the cleaning request signal.

In one embodiment, the self-moving device comprises a timer, a cleaning cycle is preset, and the timer starts timing from completion of cleaning of the charging panel last time and sends the cleaning request signal to the control module when the cleaning cycle expires.

In one embodiment, the control module determines whether the effective working electric energy received by the energy consumption device from the photoelectric conversion unit decreases, and generates a cleaning request signal if the effective working electric energy decreases and reaches a threshold.

In one embodiment, the cleaning warning signal comprises an optical signal, a sound signal, or prompt information sent to a user terminal.

In one embodiment, within a time interval between two consecutive times that the self-moving device completes covering the working area, the self-moving device is located at a location at which illumination intensity satisfies a preset level, and a time in which the photoelectric conversion unit keeps working is greater than a time in which the self-moving device keeps moving and working.

In one embodiment, when the charging panel is in an unfolded state, the self-moving device stops moving.

In one embodiment, when the charging panel is in an unfolded state, the self-moving device is located at a location at which illumination intensity satisfies a preset level.

In one embodiment, when the self-moving device moves, the charging panel is in a closed state.

An automatic working system, comprising a self-moving device, configured to move and work in a working area, wherein: the self-moving device comprises a housing, a moving module, and a control module, and the control module controls the moving module to actuate the self-moving device to move; the self-moving device further comprises a charging apparatus, and the charging apparatus comprises a photoelectric conversion unit, configured to receive optical energy, and convert the received optical energy into electric energy; and the self-moving device further comprises an energy storage unit, configured to store the electric energy obtained by conversion by the photoelectric conversion unit and provide energy for moving and working of the self-moving device, wherein the electric energy obtained by conversion by the photoelectric conversion unit is a unique energy source of the energy storage unit.

An automatic working system, comprising: a self-moving device, configured to move and work in a working area and comprising a housing, a moving module, and a control module, wherein the control module controls the moving module to actuate the self-moving device to move; and a charging apparatus, configured to provide energy for moving and working of the self-moving device, wherein when the automatic working system works, the charging apparatus is at least partially located in the working area, and the charging apparatus that is located in the working area is only mounted on the housing of the self-moving device; and the charging apparatus comprises a photoelectric conversion unit, wherein the photoelectric conversion unit receives optical energy and converts the received optical energy into electric energy.

An automatic working system, comprising: a self-moving device, configured to move and work in a working area and comprising a housing, a moving module, and a control module, wherein the control module controls the moving module to actuate the self-moving device to move; and an energy conversion unit, configured to convert external energy into internally stored energy of the self-moving device, wherein the energy conversion unit only comprises a photoelectric conversion unit, and is located on the self-moving device.

The present invention further provides an automatic working system, capable of providing energy required by itself for working, the automatic working system includes a self-moving device, and the self-moving device includes: a moving module, driven by a driving motor to actuate the self-moving device to move; and an energy module, where the energy module includes a photoelectric conversion unit, and the photoelectric conversion unit receives optical energy and converts the received optical energy into electric energy, where the energy module further includes an energy storage unit, configured to store the electric energy obtained by conversion by the photoelectric conversion unit; and the energy storage unit or the photoelectric conversion unit provides energy for moving and working of the self-moving device.

In one embodiment, the energy directly or indirectly provided by the photoelectric conversion unit for moving and working of the self-moving device is greater than or equal to energy consumed by the self-moving device for completing a working task.

In one embodiment, an average value of a total power consumed by the self-moving device for moving and working is referred to as a first power; a time required by the self-moving device for completing a working task is referred to as an effective working time; and the energy directly or indirectly provided by the photoelectric conversion unit for moving and working of the self-moving device is greater than or equal to a product of the first power and the effective working time.

In one embodiment, the self-moving device further includes a work execution module, driven by a work execution motor to execute a working task; the self-moving device has an area-to-power ratio, where the area-to-power ratio is a ratio of a receiving area of the photoelectric conversion unit to 1/4 of a sum of maximum powers of the driving motor and the work execution motor of the self-moving device; and the area-to-power ratio is greater than or equal to 5.3 m²/kW.

In one embodiment, the self-moving device has an area-to-mass ratio, where the area-to-mass ratio is a ratio of the receiving area of the photoelectric conversion unit to mass of the self-moving device; and the area-to-mass ratio is greater than or equal to 0.019 m²/kg.

In one embodiment, the self-moving device includes a body; the energy module of the self-moving device includes a charging panel, disposed at a top of the body of the self-moving device; and the photoelectric conversion unit is disposed on the charging panel.

In one embodiment, the charging panel protrudes from the body of the self-moving device in a moving direction of the self-moving device; the self-moving device further includes a contactless sensor, configured to detect whether there is an obstacle in the moving direction of the self-moving device; the self-moving device further includes a control module, where when the contactless sensor detects that there is an obstacle in the moving direction of the self-moving device, the control module controls the moving module to actuate the self-moving device to adjust a moving manner, to prevent the charging panel from colliding with the obstacle.

In one embodiment, the charging panel is controllably in an unfolded state or a closed state, when the charging panel is in the unfolded state, at least some parts of the charging panel protrude from the body in a direction parallel to a working plane, and when the charging panel is in the closed state, at least some parts of the charging panel pivotally rotate to overlap each other.

In one embodiment, the photoelectric conversion unit and the charging panel are integrally formed and are in a thin film shape.

In one embodiment, the self-moving device includes a control module, configured to set a first threshold voltage and a second threshold voltage of the energy storage unit, where after determining that a voltage of the energy storage unit is greater than or equal to the second threshold voltage, the control module controls the self-moving device to start working; and when determining that the voltage energy storage unit is less than or equal to the first threshold voltage, the control module controls the self-moving device to stop working, where the first threshold voltage is less than the second threshold voltage.

In one embodiment, the photoelectric conversion unit has a maximum power point voltage, and the maximum power point voltage is an output voltage of the photoelectric conversion unit when a conversion power of the photoelectric conversion unit reaches a maximum; and a ratio of a difference between the first threshold voltage or the second threshold voltage and the maximum power point voltage to the maximum power point voltage is not greater than 0.2.

In one embodiment, the energy module further includes a charging management unit, the charging management unit includes a voltage converter, and the voltage converter is electrically connected to the photoelectric conversion unit and the energy storage unit; the photoelectric conversion unit has a maximum power point voltage, and the maximum power point voltage is an output voltage of the photoelectric conversion unit when a conversion power of the photoelectric conversion unit reaches a maximum; an input voltage of the voltage converter matches the output voltage of the photoelectric conversion unit, to maintain the output voltage of the photoelectric conversion unit at the maximum power point voltage; and an output voltage of the voltage converter matches the voltage of the energy storage unit.

In one embodiment, the control module estimates illumination intensity of a location of the self-moving device; when determining that the voltage of the energy storage unit is less than or equal to the first threshold voltage, the control module controls the moving module to actuate the self-moving device to move to a location at which illumination intensity satisfies a preset condition, so that the photoelectric conversion unit converts optical energy into electric energy, to increase the voltage of the energy storage unit.

In one embodiment, the self-moving device includes a first working mode and a second working mode, and in the first working mode, the control module controls the moving module to actuate the self-moving device to move along a preset path; and when determining that the voltage of the energy storage unit is less than or equal to the first threshold voltage, the control module controls the self-moving device to switch from the first working mode to the second working mode, the control module controls the moving module to actuate the self-moving device to move to a location at which illumination intensity satisfies a preset condition, and when determining that the voltage of the energy storage unit is increased to the second threshold voltage, the control module controls the self-moving device to return, and further, controls the self-moving device to switch from the second working mode to the first working mode.

In one embodiment, the self-moving device includes a positioning apparatus, configured to receive a satellite signal, and the control module determines strength of the satellite signal received by the positioning apparatus to estimate illumination intensity of a location of the self-moving device.

In one embodiment, the self-moving device further includes a storage module, configured to store information of a location at which illumination intensity satisfies a preset condition in the working area, and the self-moving device further includes a positioning apparatus, where the control module compares a current location of the self-moving device with the stored location at which illumination intensity satisfies the preset condition, to estimate illumination intensity at the location of the self-moving device.

In one embodiment, the self-moving device includes an illumination sensor, and the control module estimates illumination intensity at a location of the self-moving device according to output of the illumination sensor.

In one embodiment, the self-moving device includes a positioning apparatus, further including a wireless communications apparatus, configured to receive climate information related to a location of the self-moving device, and the self-moving device further includes a control module, configured to formulate a working time plan according to the climate information.

In one embodiment, the self-moving device includes a clock, the climate information received by the self-moving device includes illumination intensity information, and the control module formulates the working time plan according to a relationship between illumination intensity and a time.

The present invention further provides an automatic working system, including a self-moving device, where the self-moving device includes: a charging apparatus, including a photoelectric conversion unit, configured to receive optical energy and convert the received optical energy into electric energy, so as to provide energy for moving and working of the self-moving device; and the electric energy obtained by conversion by the photoelectric conversion unit is a unique energy source of the self-moving device.

In one embodiment, the self-moving device includes a body; the charging apparatus includes a charging panel, disposed at a top of the body of the self-moving device; and the photoelectric conversion unit is disposed on the charging panel.

In one embodiment, the charging apparatus includes an energy storage unit, configured to store the electric energy obtained by conversion by the photoelectric conversion unit, and provide power for moving and working of the self-moving device; and the self-moving device includes a control module, configured to set a first threshold voltage and a second threshold voltage of the energy storage unit, where after determining that a voltage of the energy storage unit is greater than or equal to the second threshold voltage, the control module controls the self-moving device to start working; and when determining that the voltage energy storage unit is less than or equal to the first threshold voltage, the control module controls the self-moving device to stop working, where the first threshold voltage is less than the second threshold voltage.

In one embodiment, the photoelectric conversion unit has a maximum power point voltage, and the maximum power point voltage is an output voltage of the photoelectric conversion unit when a conversion power of the photoelectric conversion unit reaches a maximum; and a ratio of a difference between the first threshold voltage or the second threshold voltage and the maximum power point voltage to the maximum power point voltage is not greater than 0.2.

In one embodiment, the charging apparatus further includes a charging management unit, the charging management unit includes a voltage converter, and the voltage converter is electrically connected to the photoelectric conversion unit and the energy storage unit; the photoelectric conversion unit has a maximum power point voltage, and the maximum power point voltage is an output voltage of the photoelectric conversion unit when a conversion power of the photoelectric conversion unit reaches a maximum; an input voltage of the voltage converter matches the output voltage of the photoelectric conversion unit, to maintain the output voltage of the photoelectric conversion unit at the maximum power point voltage; and an output voltage of the voltage converter matches the voltage of the energy storage unit.

The present invention further provides an automatic working system, including a self-moving device, where the self-moving device includes: a first charging apparatus, including a photoelectric conversion unit, configured to receive optical energy and convert the received optical energy into electric energy, so as to provide energy for moving and working of the self-moving device; and the energy provided by the first charging apparatus for moving and working of the self-moving device is greater than or equal to energy consumed by the self-moving device for moving and working.

In one embodiment, the automatic working system further includes a second charging apparatus, configured to provide energy for moving and working of the self-moving device, where the second charging apparatus is a charging station.

Compared with the prior art, the present invention has the following beneficial effects: for the automatic working system, it is unnecessary to dispose a fixed charging station for the self-moving device, and when electric energy of the self-moving device is not enough to satisfy working requirements, the self-moving device does not need to return to a charging station to be charged, so as to avoid a trouble of mounting a fixed charging station and lower costs of the automatic working system, so that the self-moving device is flexibly chargeable and has high working efficiency.

### BRIEF DESCRIPTION OF THE DRAWINGS

The foregoing objectives, technical solutions, and advantageous effects of the present invention can be achieved by using the following drawings:
FIG. 1 is a schematic diagram of an automatic working system according to a first embodiment of the present invention;
FIG. 2 is a schematic structural diagram of an automatic mower according to the first embodiment of the present invention;
FIG. 3 is a diagram of composition of an energy module of an automatic mower according to the first embodiment of the present invention;
FIG. 4 is a curve diagram of an output power characteristic of a photoelectric conversion unit according to the first embodiment of the present invention;
FIG. 5(a) and FIG. 5(b) are working flowcharts of the automatic mower according to the first embodiment of the present invention;
FIG. 5(c) is a working flowchart of an automatic mower according to a second embodiment of the present invention;
FIG. 6 is a schematic diagram of a moving path of the automatic mower according to the first embodiment of the present invention;
FIG. 7 is a curve diagram of a lithium battery discharging characteristic according to the first embodiment of the present invention;
FIG. 8 is a flowchart of working time formulation of the automatic working system according to the first embodiment of the present invention;

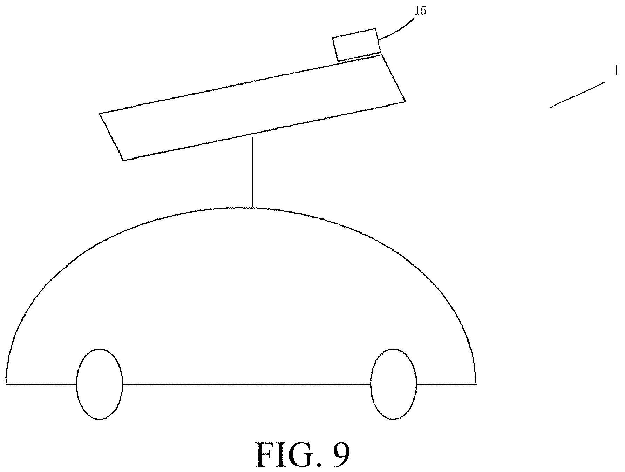

FIG. 9 is a schematic structural diagram of a bird scaring apparatus according to another embodiment of the present invention;
FIG. 10 is a schematic structural diagram of a cleaning apparatus according to another embodiment of the present invention;
FIG. 11 is a schematic diagram of a solar panel connection mechanism according to another embodiment of the present invention; and
FIG. 12 is a flowchart of construction of an illumination map and charging according to the first and/or second embodiment of the present invention.

### DETAILED DESCRIPTION

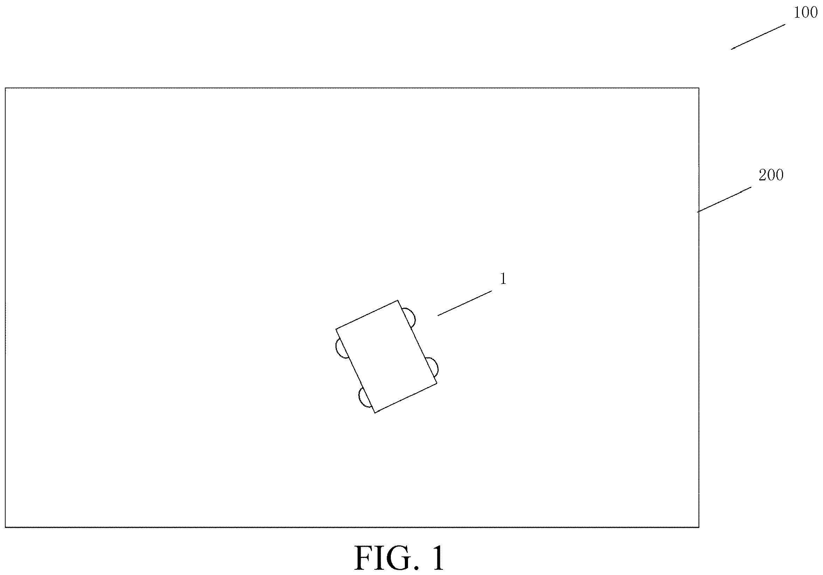

FIG. 1 is a schematic diagram of an automatic working system 100 according to a first embodiment of the present invention. The automatic working system 100 can provide energy required for its work. In this embodiment, the automatic working system 100 includes a self-moving device, and the self-moving device moves and works in a working area defined by a boundary 200. In this embodiment, the self-moving device is an automatic mower 1. Certainly, the self-moving device may alternatively be an unmanned device such as an automatic watering device. The boundary of the working area may be formed by a boundary line. Alternatively, no boundary line is laid, and the automatic mower recognizes the boundary of the working area by using a camera or a capacitive lawn recognition sensor.

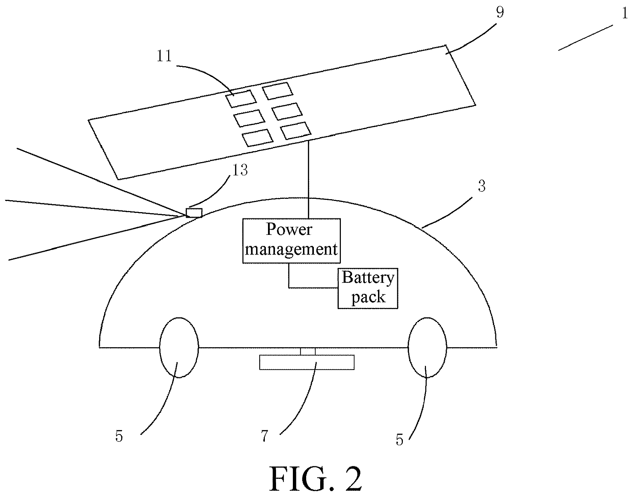

FIG. 2 is a schematic structural diagram of an automatic mower 1 according to this embodiment. The automatic mower 1 includes a housing 3, a moving module, a cutting module, an energy module, a control module, and the like. The moving module, the cutting module, the energy module, and the control module are all mounted on the housing 3. The moving module includes a wheel set 5, driven by a driving motor to actuate the automatic mower 1 to move. The cutting module includes a cutting component 7, driven by a cutting motor to execute mowing work. The automatic mower includes an energy consumption device. The energy consumption device includes a device that consumes energy for actuating the self-moving device to move and work. Specifically, the energy consumption device includes a motor driving the automatic mower to move and/or work, for example, the foregoing driving motor and cutting motor.

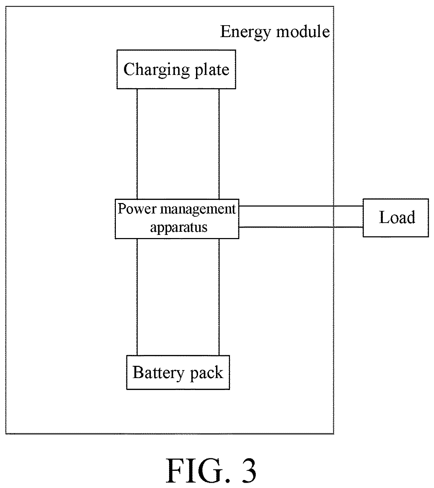

In this embodiment, the energy module includes a charging apparatus. The charging apparatus includes a charging panel 9, disposes at top of the body of the automatic mower 1. The charging apparatus includes several photoelectric conversion units 11, disposed on the charging panel 9. The photoelectric conversion unit 11 receives optical energy and converts the received optical energy into electric energy. The energy module further includes an energy storage unit, storing the electric energy obtained by conversion by the photoelectric conversion unit 11. Specifically, the energy storage unit is a battery pack. The battery pack is mounted on the housing 3 and supplies power for moving and working of the automatic mower 1. The energy module further includes a power management apparatus. The power management apparatus includes a charging management unit and a discharging management unit, to manage a charging process of the battery pack and a process in which the battery pack supplies power to the automatic mower 1. Composition of the energy module of the automatic mower 1 is shown in FIG. 3. In this embodiment, the energy storage unit and the charging management unit form a part of a charging apparatus in a broad sense. In this embodiment, the charging apparatus of the automatic mower 1 is disposed on the automatic mower 1 and moves together with the automatic mower 1. The automatic mower 1 moves to a position at which it can be illuminated. The photoelectric conversion unit 11 converts optical energy into electric energy. The battery pack stores the electric energy and supplies power for moving and working of the automatic mower 1. In this embodiment, effective working electric energy that is received by the energy consumption device from the photoelectric conversion unit and that is converted by the photoelectric conversion unit is greater than or equal to energy consumed by the energy consumption device to actuate the automatic mower to move and work. Herein, with regard to the effective working electric energy, charging efficiency β of converting electric energy output by the photoelectric conversion unit into chemical energy of the battery pack and a discharging utilization ratio σ at which chemical energy is converted into electric energy during discharging of the battery pack are taken into consideration. In this embodiment, optical energy is used as a unique energy source to supply power for moving and working of the automatic mower 1. To be specific, for the automatic working system 100 of this embodiment, it is unnecessary to dispose a fixed charging station for the automatic mower 1. When electric energy of the automatic mower 1 is not enough to satisfy working requirements, the automatic mower 1 does not need to return to a charging station to be charged, so as to avoid a trouble of mounting a fixed charging station and lower costs of the automatic working system 100, so that the automatic mower 1 is flexibly chargeable and has high working efficiency. In this embodiment, the photoelectric conversion unit, as a unique energy conversion unit, converts external energy into internally stored energy of the automatic mower, and the energy conversion unit is located on the automatic mower. The electric energy obtained by conversion by the photoelectric conversion unit is a unique energy source of the battery pack.

In this embodiment, the battery pack stores the electric energy obtained by conversion by the photoelectric conversion unit, and the battery pack provides energy for moving and working of the automatic mower 1. In another embodiment, the photoelectric conversion unit 11 may alternatively directly supply power for moving and working of the automatic mower 1. To stabilize power supply of the photoelectric conversion unit, a voltage stabilization unit may be added and be electrically connected to output of the photoelectric conversion unit.

In this embodiment, the several photoelectric conversion units 11 are arranged as an array on the charging panel 9. The photoelectric conversion units 11 are connected in series to each other. A product obtained by multiplying a receiving area of each photoelectric conversion unit 11 by a quantity of the photoelectric conversion units 11 is a total receiving area of the photoelectric conversion units 11. In this embodiment, the total receiving area of the photoelectric conversion units is greater than or equal to a projected area of the housing 3 of the automatic mower on a working plane. If the total receiving area of the photoelectric conversion units 11 is larger, a capability of converting optical energy into electric energy of the charging panel 9 is stronger, and charging power is higher. A minimum area of the charging panel 9 includes the total receiving area of the photoelectric conversion units 11, an area of gaps between the photoelectric conversion units 11, an area of edges of the charging panel 9, and the like. Therefore, the minimum area of the charging panel 9 is slightly larger than the total receiving area of the photoelectric conversion units 11.

In this embodiment, the automatic mower 1 works outdoors. Optical energy received by the photoelectric conversion unit 11 is solar energy. To make it easy to understand, the charging panel 9 is referred to as a solar panel. In this embodiment, photoelectric conversion efficiency of the photoelectric conversion unit 11 is greater than or equal to 12%. Monocrystalline silicon or polycrystalline silicon is used for the photoelectric conversion unit. As described above, the solar panel includes several photoelectric conversion units. Photoelectric conversion efficiency of the solar panel depends on the photoelectric conversion efficiency of the photoelectric conversion unit, and is also affected by a state of the art. In this embodiment, the photoelectric conversion efficiency of the solar panel is set to 12%. To be specific, if the solar panel per square meter can receive solar energy converted into a power of 1000 W in equivalent value, the solar panel per square meter can output an electric power of 120 W. The photoelectric conversion efficiency of the solar panel may be considered as an inherent attribute of the solar panel. In another embodiment, the photoelectric conversion efficiency of the photoelectric conversion unit is greater than or equal to 17% or even above 20%.

In a conventional solar panel, glass is used as a surface protection layer of the photoelectric conversion unit, to protect the photoelectric conversion unit from being affected by an external environment, and particularly, to prevent the photoelectric conversion unit from being damaged by a falling external object. A disadvantage of a glass protection layer is a large weight. If the glass protection layer is applied to the automatic mower, a power consumed by the automatic mower is increased. To resolve the foregoing problem, in this embodiment, a glue is dripped on a surface of the photoelectric conversion unit. To be specific, a protection layer of the photoelectric conversion unit is made from an epoxy glue. Density of the charging panel is less than or equal to 10 kg/m², the charging panel has a small weight and can save energy consumed by the automatic mower.

In this embodiment, the charging panel has flexibility. Specifically, the charging panel is formed with an outer contour fitting the housing. An advantage of such an approach is that design of an appearance of the automatic mower is more flexible and is not limited by a regular shape of the charging panel.

A magnitude of an electric power that a solar panel can output is related to illumination intensity. If the illumination intensity is higher, the electric power output by the solar panel is higher. Electric energy that the solar panel can output is also related to an illumination time. When the illumination intensity is fixed, if a time that illumination lasts is longer, the electric energy that the solar panel can output is high.

It can be understood that the working area of the automatic mower is a lawn. Therefore, the working area of the automatic mower is usually an area in which an illumination condition is relatively good. Particular, in seasons when grass exuberantly grows, the solar panel can receive relatively sufficient illumination. In winter when illumination is relatively weak, it is almost unnecessary to maintain a lawn by using the automatic mower. Using the Northern Hemisphere as an example, the automatic mower mainly works in a period from April to October. A working situation of the automatic mower in April is used as an example below to analyze a relationship between electric energy that the solar panel can provide and energy consumed by the automatic mower for moving and working. In another working time, an illumination condition of the working area of the automatic mower is better than that in April, and the solar panel can output more sufficient electric energy.

According to statistics collected by NASA on historical data of global monthly illumination situations, illumination situations of a working area at a particular location in different months, that is, optical energy H_{d} (kWh) that per square meter of the solar panel can receive each day on average in an ideal situation in the working area at the particular location, can be learned. Illumination condition data of several typical cities in the Northern Hemisphere is as follows:

| City | Latitude | Longitude | Energy received by per square meter of the solar panel each day (kW•h) |
|---|---|---|---|
| Washington, D.C. | 38°54'N | 77°02'W | 5.67 |
| London | 52°0"N | 0 | 3.62 |
| Stockholm | 59°19'N | 18°03'E | 4.08 |

According to analysis on illumination conditions of a large number of possible application areas of automatic mowers, in months in which an automatic mower works, an illumination condition of a working area can reach that energy received by per square meter of a solar panel is not lower than 3.2 kW•h.

In this embodiment, a lawn of approximately 500 m² is a target working area. In this embodiment, a cutting width (similar to a cutter head diameter) of the automatic mower ranges from 20 to 30 cm. To complete a task of maintaining a lawn, an automatic mower needs to work approximately 2.5 hours each day on average. A power consumed by the automatic mower mainly includes a power consumed by the driving motor for actuating the automatic mower to move and a power consumed by the cutting motor for actuating the cutting component to carry out mowing work. In this embodiment, the driving motor is a driving electric motor and the cutting motor is a cutting electric motor. When the automatic mower moves and works in a normal working condition, a working current of the driving electric motor ranges from approximately 0.6 A to approximately 0.8 A, a working current of the cutting electric motor ranges from approximately 1.1 A to approximately 1.3 A, a working voltage of the battery pack is stabilized at approximately 19 V, a power consumed by the driving electric motor ranges from approximately 11.4 W to approximately 15.2 W, and a power consumed by the cutting electric motor ranges from approximately 20.9 W to 24.7 W, and a total power consumed by the driving electric motor and the cutting electric motor ranges from approximately 32.3 W to approximately 39.9 W. The power consumed by the automatic mower is slightly greater than the total power consumed by the driving electric motor and the cutting electric motor, and the power consumed by the automatic mower is set to 40 W. The electric energy consumed by the automatic mower each day on average is W_{d}=40 W•2.5 h=0.100 kWh.

When the energy received by the per square meter of the solar panel each day is H_{d}=3.2 kW•h, in an ideal situation, the electric energy that the per square meter of the solar panel can output each day is H_{d}•η, wherein η is photoelectric conversion efficiency of the solar panel, and in this embodiment, η=12%, and H_{d}•η=0.384 kWh. To ensure that optical energy conversion efficiency of the solar panel is maintained at an optimal level, a specific condition needs to be satisfied. The optical energy conversion efficiency of the solar panel is related to an inclination angle of the solar panel, whether the solar panel is subject to direct solar radiation, and whether a surface of the solar panel is clean. Therefore, the electric energy that the per square meter of the solar panel can output is multiplied by a coefficient of efficiency γ. Preferably, a value of the coefficient of efficiency γ ranges from 0.6 to 0.8. In this embodiment, if y=0.7, the electric energy that the per square meter of the solar panel actually outputs is γ•H_{d}•η=0.289 kWh.

It can be learned by comparing the electric energy consumed by the automatic mower each day on average with the electric energy that the per square meter of the solar panel can output that when an area of the solar panel is greater than or equal to 0.346 m², the electric energy provided by the solar panel can satisfy a demand for electric energy consumed by the automatic mower for moving and working in a normal working condition. To be specific, the energy provided by the photoelectric conversion unit for moving and working of the automatic mower is greater than or equal to energy consumed by the automatic mower for completing a working task. An average value of the total power consumed by the automatic mower for moving and working is referred to as a first power, and in this embodiment, the first power is 40 W. A time needed by the automatic mower for completing the working task is referred to as an effective working time, and in this embodiment, the effective working time is 2.5 h. The energy provided by the photoelectric conversion unit for moving and working of the automatic mower is greater than or equal to a product of the first power and the effective working time.

In this embodiment, considering that in a moving and working process, the automatic mower may encounter a special working condition such as working on a slope, the electric energy actually consumed by the automatic mower is slightly higher. Therefore, a value of an area of the solar panel is greater than or equal to 0.35 m², to satisfy a demand for electric energy consumed by the automatic mower for moving and working.

In this embodiment, a lawn of approximately 500 m² is the working area of the automatic mower. It can be understood that if the working area of the automatic mower is larger, a working time needed by the automatic mower for completing a lawn maintaining task is longer, and a demand for power consumed is higher. On the contrary, if the working area of the automatic mower is smaller, the working time needed by the automatic mower for completing the lawn maintaining task is shorter, and the demand for power consumed is lower. For a lawn of approximately 100 m² to approximately 300 m², to complete the lawn maintaining task, the automatic mower needs work for 1.5 hours each day on average. When the power consumed by the automatic mower is unchanged, the electric energy W_{d} consumed by the automatic mower each day on average is approximately 0.060 kWh. Therefore, when the area of the solar panel is greater than or equal to 0.208 m², the electric energy provided by the solar panel can satisfy a demand for electric energy consumed by the automatic mower for moving and working in a normal working condition. For a lawn having a relatively small area, a working condition is usually relatively simple, and a requirement for performance of the automatic mower is relatively low. A cutter head diameter of the automatic mower is relatively small, a rotation speed of the electric motor is relatively low, and a power consumed is relatively low. Therefore, when an area of the solar panel is set to be greater than or equal to 0.200 m², the electric energy provided by the solar panel can satisfy a demand for electric energy consumed by the automatic mower for moving and working.

In this embodiment, using performance of an automatic mower working in a lawn of approximately 500 m² as an example, a condition that an area parameter of a solar panel needs to satisfy for satisfying a demand for energy consumed by the automatic mower is analyzed. According to different configurations of the automatic mower, the automatic mower consumes different powers. For example, for an automatic mower working in a lawn of a large area (for example, 1000 to 2000 m²), a cutter head diameter is relatively large, and a cutting width can reach 50 to 60 mm. Therefore, an electric power consumed by a cutting electric motor is relatively high, and in addition, a rotation speed of the driving electric motor is relatively high. Further, because mass of the automatic mower is relatively large, a power consumed by the driving electric motor to actuate the automatic mower to move is relatively high. In addition, according to different situations of working areas, powers consumed by the automatic mower are different. For example, a power consumed by an automatic mower working in a complex working area is relatively high, and a power consumed by an automatic mower working in a working area having relatively dense grass is relatively high. When the automatic mower includes an additional functional device, for example, includes a positioning device or the like, a power consumed by the automatic mower is also increased. The power consumed by the automatic mower directly affects a minimum area of the solar panel for providing enough electric energy for the automatic mower. Specifically, the minimum area of the solar panel and the power consumed by the automatic mower are increased in a same direction. Because there is uncertainty in the power consumed by the automatic mower, it is necessary to check a ratio of the area of the solar panel to an average power consumed by the automatic mower. Usually, the cutting electric motor and the driving electric motor of the automatic mower respectively have current-limiting currents, and when a current of the cutting electric motor is greater than its current-limiting current, the cutting electric motor stops, to protect the cutting electric motor. Likewise, when a current of the driving electric motor is greater than its current-limiting current, the driving electric motor stops, to protect the driving electric motor. In a situation in which working voltages of the cutting electric motor and the driving electric motor are basically stable, when the current of the cutting electric motor or the driving electric motor reaches the current-limiting current, powers of the cutting electric motor and the driving electric motor reach maximum values. When the automatic mower moves and works in a normal working condition, an average consumed power is approximately 1/4 of a sum of a maximum power of the cutting electric motor and a maximum power of the driving electric motor. Moreover, the area of the solar panel is close to a total receiving area of the photoelectric conversion unit. Therefore, a ratio of a receiving area of the photoelectric conversion unit to 1/4 of the sum of the maximum powers of the cutting electric motor and the driving electric motor of the automatic mower is an area-to-power ratio of the automatic mower. In this embodiment, the current-limiting currents of the cutting electric motor and the driving electric motor are both 4 A, and a working voltage is 19 V. The total receiving area of the photoelectric conversion unit occupies approximately 96% of the area of the solar panel. The electric energy provided by the solar panel needs to satisfy a power consumption requirement of the automatic mower, and the area-to-power ratio needs to be greater than or equal to 8.9 (m²/kW).

Likewise, if an average daily working time of the automatic mower being 1.5 h is used as a standard, for example, when the working area of the automatic mower is a lawn of 100 to 300 m², the electric energy provided by the solar panel needs to satisfy the power consumption requirement of the automatic mower, and the area-to-power ratio needs to be greater than or equal to 5.3 (m²/kW).

On the other hand, power consumption of the automatic mower is directly related to the mass of the automatic mower. If the mass of the automatic mower is larger, more electric energy is consumed by the automatic mower. In addition, the size of a working area to which the automatic mower is applicable is also directly reflected by the mass of the automatic mower. If the working area of the automatic mower is larger, a volume of the automatic mower is large, and the mass is also larger. Because the electric energy consumed by the automatic mower is related to the average daily working time of the automatic mower, and the average daily working time of the automatic mower is also related to the size of the working area, the area of the solar panel and a parameter capable of reflecting the size of the working area of the automatic mower are comprehensively estimated, so as to better check whether the electric energy provided by the solar panel satisfies a demand for electric energy required by the automatic mower for working. A ratio of the receiving area of the photoelectric conversion unit to the mass of the automatic mower is defined as an area-to-mass ratio of the automatic mower. In this embodiment, the mass of the automatic mower is approximately 16 kg, the electric energy provided by the solar panel needs to satisfy a power consumption requirement of the automatic mower, and the area-to-power ratio needs to be greater than or equal to 0.021 (m²/kg). The mass of the automatic mower working in a lawn of a small area is approximately 10 kg, the area of the solar panel is greater than or equal to 0.200 m², and the area-to-power ratio of the automatic mower is greater than or equal to 0.019 (m²/kg).

The optical energy that the solar panel can receive is limited. Therefore, how to fully use the optical energy received by the solar panel and convert it into electric energy required by the automatic mower for working is significantly important. If an output power of the photoelectric conversion unit is higher, optical energy conversion efficiency is higher. A maximum output power of the photoelectric conversion unit is an inherent attribute of the photoelectric conversion unit, and in a process of converting, by the photoelectric conversion unit, the optical energy into the electric energy, the output power of the photoelectric conversion unit is affected by an output voltage.

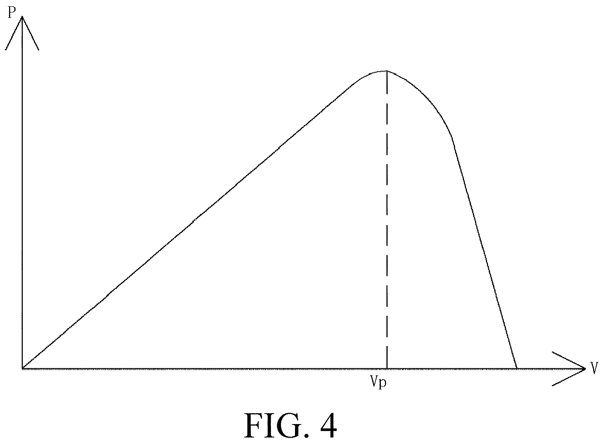

An output power characteristic curve of the photoelectric conversion unit is shown in FIG. 4. The output power of the photoelectric conversion unit shows a trend of first increasing and then decreasing as the output voltage of the photoelectric conversion unit increases. An output voltage of the photoelectric conversion unit when the output power of the photoelectric conversion unit reaches a maximum is referred to as a maximum power point voltage V_{P}, and the maximum power point voltage is an inherent attribute of the photoelectric conversion unit. In a process in which the photoelectric conversion unit charges the battery pack, the output voltage of the photoelectric conversion unit is related to the voltage of the battery pack. When the battery pack is fully charged, the voltage reaches a maximum Vₘ, and as energy of the battery pack is consumed, the voltage of the battery pack drops until a critical value is reached. When the voltage of the battery pack is close to the maximum power point voltage of the photoelectric conversion unit, the output voltage of the photoelectric conversion unit is close to the maximum power point voltage. In this case, the output power of the photoelectric conversion unit is highest. To be specific, the charging power of the battery pack is highest. In this embodiment, because the maximum power point voltage of the photoelectric conversion unit is fixed, a maximum power point voltage obtained by connecting N photoelectric conversion units in series is N•V_{P}, where N is a quantity of the photoelectric conversion units connected in series. The battery pack is formed by connecting a plurality of battery cells, a maximum voltage of a single battery cell is an inherent attribute of the battery cell, and a maximum voltage of M battery cells connected in series is M•Vₘ, where M is a quantity of the battery cells connected in series. In a moving and working process of the automatic mower, the voltage of the battery pack is stabilized at α•M•Vₘ, where α is a coefficient of an actual working voltage of the battery pack to a voltage of the battery pack when the battery pack is fully charged, and α≤1. To improve charging efficiency of the battery pack, the output power of the photoelectric conversion unit is enabled to reach a maximum, and the working voltage of the battery pack is enabled to be close to the maximum power point voltage of the photoelectric conversion unit. To be specific, α•M•Vₘ≈N•V_{P}(^{∗}). In this embodiment, a maximum power point voltage of a single photoelectric conversion unit is 0.5 V, 38 photoelectric conversion units are connected in series, and a maximum power point voltage obtained after the series connection is 19 V. The battery pack includes 5 battery cells connected in series, a maximum voltage of each battery cell is 4.2 V, α is set to range from 0.82 to 0.92, and the working voltage of the battery pack is stabilized at approximately 19 V.

The photoelectric conversion unit is enabled to keep maximum power output by stabilizing the voltage of the battery pack at the maximum power point voltage of the photoelectric conversion unit, so as to fully use the optical energy received by the photoelectric conversion unit.

In this embodiment, a method for stabilizing the voltage of the battery pack at the maximum power point voltage of the photoelectric conversion unit is as follows:
The control module of the automatic mower detects a voltage of the battery pack, and instructs the automatic mower to stop cutting work and travel to a location at which illumination is stronger when the voltage of the battery pack is less than or equal to the first threshold voltage, so that the photoelectric conversion unit can receive enough optical energy, to replenish the battery pack with electric energy. When the voltage of the battery pack reaches the second threshold voltage, the control module determines that the automatic mower can enter a working state. The second threshold voltage is higher than the first threshold voltage. In this embodiment, the second threshold voltage is enabled to be close to the maximum power point voltage of the photoelectric conversion unit. Preferably, the second threshold voltage is set to 1 to 1.2 times the maximum power point voltage. When the voltage of the battery pack is close to the maximum power point voltage, charging efficiency of the battery pack is highest, and when the battery pack is continuously charged, the voltage increases, and the charging efficiency decreases. In this embodiment, when the voltage of the battery pack reaches the second threshold voltage, the automatic mower enters the working state. Certainly, in another embodiment, when the voltage of the battery pack reaches the second threshold voltage, the automatic mower may be instructed to travel to a preset location and then enter the working state. In this embodiment, when the automatic mower is in the working state, the battery pack, on the one hand, supplies power for moving and working of the automatic mower and consumes electric energy, and on the other hand, continues storing the electric energy converted by the photoelectric conversion unit. The working voltage of the battery pack is stabilized close to the maximum power point voltage of the photoelectric conversion unit, and the output power of the photoelectric conversion unit is stabilized close to a maximum point, so that optical energy can be fully used. In this embodiment, the first threshold voltage is also enabled to be close to the maximum power point voltage of the photoelectric conversion unit. In one embodiment, the first threshold voltage is set to 0.8 to 1 times the maximum power point voltage. When the voltage of the battery pack drops to the first threshold voltage, if the automatic mower continues working, the voltage of the battery pack drops, and charging efficiency of the battery pack decreases. When the voltage of the battery pack drops to the first threshold voltage, the automatic mower is instructed to stop cutting work and travel to a location at which illumination is stronger to be replenished with electric energy, to increase the voltage of the battery pack, so that the output voltage of the photoelectric conversion unit is always stabilized close to the maximum power point voltage. This is beneficial to converting optical energy into electric energy at maximum efficiency. In this embodiment, a ratio of a difference between either the first threshold voltage or the second threshold voltage and the maximum power point voltage to the maximum power point voltage is not greater than 0.2. In this embodiment, the first threshold voltage is set to be close to the maximum power point voltage of the photoelectric conversion unit, so that before an electric quantity of the battery pack is exhausted, the automatic mower has enough time to travel to a location at which illumination is stronger. Therefore, working requirements of the automatic mower can be satisfied.

In this embodiment, when determining that a voltage of a single battery cell is less than 3.5 V or the voltage of the battery pack is less than 17.5 V, the control module instructs the automatic mower to travel to a location at which illumination is stronger to be replenished with electric energy. When determining that a voltage of a single battery cell is greater than 3.8 V or the voltage of the battery pack is greater than 19 V, the control module determines that the automatic mower can enter the working state. To be specific, the first threshold voltage is set to 17.5 V, and the second threshold voltage is set to 19 V.

Costs of the foregoing method of maintaining the output power of the photoelectric conversion unit at the maximum power are low.

In another embodiment of the present invention, a voltage converter is configured to stabilize the output voltage of the photoelectric conversion unit at the maximum power point voltage of the photoelectric conversion unit. Specifically, the charging management unit includes a voltage converter. An input end of the voltage converter is connected to an output end of the photoelectric conversion unit, and an output end of the voltage converter is connected to a charging interface of the battery pack. An input voltage of the voltage converter matches the output voltage of the photoelectric conversion unit, and an output voltage of the voltage converter matches the voltage of the battery pack. The voltage converter stabilizes a voltage on its input end at a preset value. In this embodiment, to be specific, the output voltage of the photoelectric conversion unit is stabilized at the maximum power point voltage. The output voltage of the voltage converter can change as the electric quantity of the battery pack changes. In this way, the output power of the photoelectric conversion unit can be always maintained at the maximum power. In addition, the working voltage of the battery pack is not limited, so that charging and discharging of the battery pack are more flexible. In this embodiment, the voltage converter may be specifically an MPPT controller, that is, a "maximum power point tracking" controller. The MPPT controller can detect a power generation voltage of the solar panel in real time, to enable the solar panel to output electric energy at a maximum power.

In the first embodiment of the present invention, the automatic mower further includes a contactless sensor 13, configured to detect whether there is an obstacle in a moving direction of the automatic mower, and if the contactless sensor detects that there is an obstacle in the moving direction of the automatic mower, the automatic mower adjusts a moving manner, to prevent the solar panel from colliding with the obstacle. In this embodiment, the contactless sensor 13 is an ultrasonic sensor. In this embodiment, it is considered that the housing, the moving module, the cutting module, and the like of the automatic mower form the body of the automatic mower, and the solar panel is disposed at the top of the body of the automatic mower. The area of the solar panel is relatively large, and the dimension of the solar panel in a horizontal direction may exceed the body of the automatic mower. Therefore, if the automatic mower collides with an obstacle, the solar panel is subject to impact, and the impact causes damage to the solar panel. To prevent the solar panel from being damaged by collision between the automatic mower and the obstacle, an ultrasonic sensor is disposed on the automatic mower, to detect whether there is an obstacle in a moving direction of the automatic mower, and if the ultrasonic sensor detects that there is an obstacle in the moving direction of the automatic mower, the automatic mower is instructed to decelerate, turn, or shut down, so that before getting in contact with the obstacle, the automatic mower changes a traveling direction or stops moving, to prevent the solar panel from colliding with the obstacle, thereby protecting the solar panel. Certainly, in another embodiment, ultrasonic sensors may alternatively be disposed at a plurality of positions on the automatic mower, to detect whether there is an obstacle in a plurality of orientations of the automatic mower, particularly, in orientations in which the solar panel possibly exceeds the body of the automatic mower, to prevent the solar panel from getting in contact with an obstacle in the orientations.

In this embodiment, the solar panel is connected to the body of the automatic mower through a connection mechanism. The solar panel is operably in an unfolded state or a closed state, when the solar panel is in the unfolded state, at least some parts of the solar panel protrude from the body in a direction parallel to a working plane, and when the solar panel is in the closed state, at least some parts of the solar panel pivotally rotate to overlap each other. The area of the solar panel is relatively large, and the dimension of the solar panel in a horizontal direction may be exceed the body of the automatic mower. To prevent the solar panel from colliding with an obstacle and further and to prevent accumulation of dust on the solar panel due to long-term exposure when the solar panel does not work, the solar panel is designed into a foldable form. When the solar panel works normally, the solar panel is in an unfolded state, so that the solar panel can fully receive optical energy. When it is detected that the automatic mower is about to collide with an obstacle, or when the solar panel is not in a working state, the solar panel is in a closed state. When the solar panel changes from the unfolded state to the closed state, a part of the solar panel, particularly, a part that exceeds the body of the automatic mower, rotates through a pivotal rotation structure, so that the dimension of the solar panel in the direction parallel to the working plane is reduced, and the solar panel does not get in contact with an obstacle before the body of the automatic mower gets in contact with the obstacle, so as to protect the solar panel from being impacted and damaged. A part of the solar panel overlaps another part through pivotal rotation, so that a surface for receiving optical energy is protected, and when the solar panel is not in a working state, the surface for receiving optical energy is not exposed and therefore, is prevented from dust accumulation, so that the solar panel can maintain high photoelectric conversion efficiency.

In another embodiment of the present invention, as an alternative solution for preventing the solar panel from colliding with an obstacle, alternatively, an protruding component may be disposed on the body of the automatic mower, and the protruding component protrudes out of the solar panel in a moving direction of the automatic mower, so that when the automatic mower collides with an obstacle, the protruding component collides with the obstacle before the solar panel collides with the obstacle, to protect the solar panel.

In another embodiment of the present invention, the photoelectric conversion unit and the charging panel are integrally formed and are in a thin film shape. To make it easy to understand, in this embodiment, a thin-film solar panel is used to supply power for moving and working of the automatic mower. The thin-film solar panel has flexibility and can be molded into different shapes to match the housing of the automatic mower, so that the automatic mower is more beautiful.

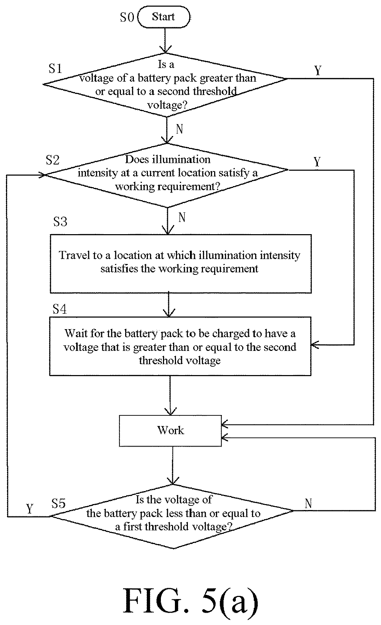

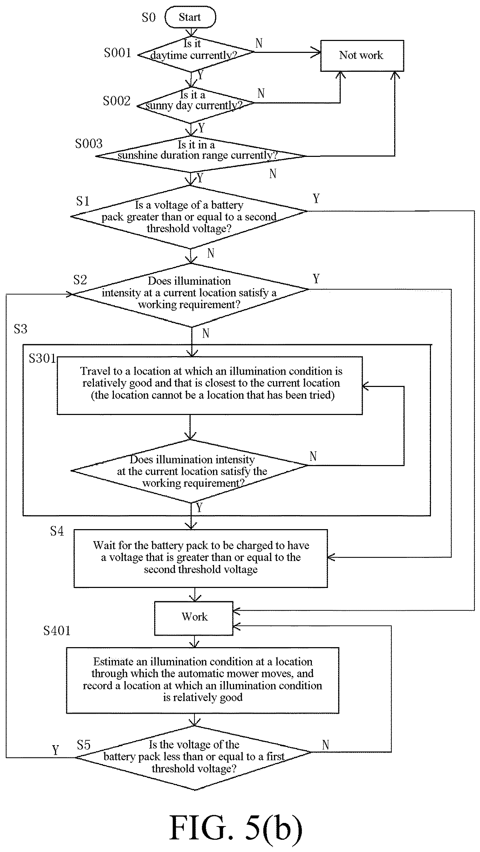

FIG. 5(a) and FIG. 5(b) are working flowcharts of the automatic mower according to the first embodiment of the present invention. Work of the automatic mower includes the following steps:
S0: Control the automatic mower to start.
S11: Determine whether a voltage of a battery pack reaches a second threshold voltage, if the voltage reaches the second threshold voltage, enter a working state, and if the voltage does not reach the second threshold voltage, perform S12.
S12: Determine whether illumination intensity at a current location satisfies a working requirement, if the illumination intensity satisfies the working requirement, perform step S14, and if the illumination intensity does not satisfy the working requirement, perform step S13.
S13: Control the automatic mower to travel to a location at which illumination intensity satisfies the working requirement, and perform step S14.
S14: Control the automatic mower to wait for a battery pack to be charged to have a voltage that reaches the second threshold voltage, and enter the working state.
S15: Determine whether the voltage of the battery pack drops to a first threshold voltage, if yes, go back to step S12, and if not, maintain the working state.

In this embodiment, the automatic mower includes a positioning apparatus. The positioning apparatus includes a satellite signal receiving unit and determines a location thereof according to the satellite signal. Specifically, the positioning apparatus is a GPS module, a DGPS module, a BeiDou positioning module, or a Galileo positioning module.

In this embodiment, the automatic mower further includes a storage module (storage unit), configured to store location information of a location at which an illumination condition is relatively good in a working area.

In this embodiment, preferably, the automatic mower is started at the location at which an illumination condition is relatively good in the working area, and stores the position information. A starting location of the automatic mower may be manually specified by a user each time the automatic mower is started, or may be determined by a location of the automatic mower when last work ends. After the automatic mower is started, the following steps are further included:
S001: Determine whether it is daytime currently, if it is not daytime, do not work, and if it is daytime, perform step S002.
S002: Determine whether it is a sunny day currently, if it is not a sunny day, do not work, and if it is a sunny day, perform step S003.
S003: Determine whether a current time falls within a sunshine duration range, if not, do not work, and if yes, perform step S11.

The control module determines whether it is daytime currently, whether it is a sunny day currently, or whether a current time falls within a sunshine duration range by detecting a voltage of the solar panel. If the voltage of the solar panel is lower than a preset value, it can be determined that it is not daytime, it is not sunny day, or it is not in the sunshine duration range currently. The control module may alternatively determine whether it is daytime or whether it is in the sunshine duration range currently by using a clock module. The control module may alternatively determine whether it is a sunny day currently, by obtaining external information, such as weather forecast, through a wireless communications module.

In step S13, controlling the automatic mower to travel to a location at which illumination intensity satisfies the working requirement includes step S301: Control the automatic mower to move to a location at which an illumination condition is relatively good and that is closest to a current location.

The storage module stores a location at which an illumination condition is relatively good in a working area, and the control module controls, according to the location at which an illumination condition is relatively good, the automatic mower to move.

The location at which an illumination condition is relatively good is usually an area that is relatively open and that is not shaded. Because an illumination situation changes as time changes, when the automatic mower moves to a location at which an illumination condition is relatively good and that is stored in the storage module, the illumination situation may have changed, and the control module still needs to determine whether illumination intensity of a current location can satisfy a working requirement of the automatic mower, and if illumination intensity of a location at which an illumination condition is relatively good and that is closest to the current location of the automatic mower cannot satisfy a working requirement of the automatic mower, controls the automatic mower to move to a next location at which an illumination condition is relatively good and that is closest to the current location of the automatic mower, where the location cannot be a location that the automatic mower has tried.

The location that satisfies a working requirement of the automatic mower usually means that enough optical energy can be provided to the solar panel to be converted into enough electric energy by the solar panel, to satisfy an energy demand for normal moving and working of the automatic mower. Whether an illumination condition at a current location can satisfy the working requirement of the automatic mower can be determined by setting a voltage threshold of the solar panel.

After the automatic mower enters the working state, that is, in a process in which the automatic mower normally moves and mows, the following steps are further included:
S401: Estimate an illumination condition at a location through which the automatic mower moves, and store a location at which an illumination condition is relatively good in a storage module.

Information of the location at which an illumination condition is good stored in the storage module is continuously updated as the automatic mower moves.

In this embodiment, when the voltage of the battery pack drops to the first threshold voltage, the automatic mower is controlled to go back to step S12. Certainly, in another embodiment, the automatic mower may alternatively be controlled to go back to step S101.

In this embodiment, because the starting location of the automatic mower is set to be a location at which an illumination condition is relatively good, after the automatic mower is started and before the automatic mower enters the working state, in step S301, the automatic mower determines that the current location is a location at which an illumination condition is relatively good.

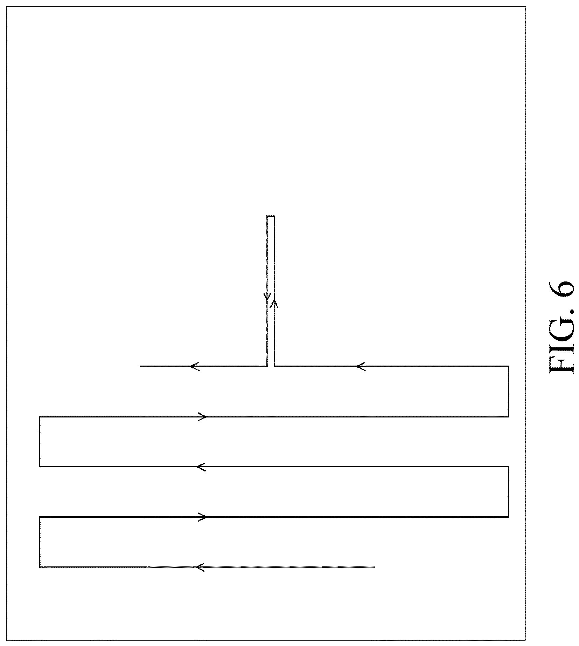

In this embodiment, the automatic mower includes a first working mode and a second working mode. In the first working mode, the automatic mower moves along a preset path, for example, along parallel straight lines. When the voltage of the battery pack is less than or equal to the first threshold voltage, the automatic mower switches from the first working mode to the second working mode. In the second working mode, the automatic mower stops mowing work. The control module controls the automatic mower to move to a location at which illumination intensity satisfies a working requirement, and controls, after the battery pack is charged to have a voltage that reaches the second threshold voltage, the automatic mower to return to a location at which the automatic mower stops the mowing work. After the automatic mower returns, the control module further controls the automatic mower to switch from the second working mode to the first working mode, and the automatic mower resumes the mowing work and continues to move according to the preset path. A moving path of the automatic mower is shown in FIG. 6.

According to the foregoing workflow of the automatic mower and the method for controlling the automatic mower to move and work, while the automatic mower works, the solar panel continuously receives optical energy to replenish energy for moving and working of the automatic mower, so as to fully use illumination in the daytime, to ensure that the electric energy obtained by conversion by the solar panel can be fully supplied as electric energy that the automatic mower needs to consume for moving and working.

In a second embodiment of the present invention, composition of an automatic working system, a structure of an automatic mower, and a control method are basically the same as those in the first embodiment. The second embodiment differs from the first embodiment in respect of using a better working manner of charging an automatic mower by using solar energy in the daytime, to enable the automatic mower to preferably work in the nighttime. Specifically, the following steps are included:
S0: Control the automatic mower to start.
S21: Determine whether it is nighttime currently, if yes, perform step S22, and if not, perform step 23.
S22: Determine whether a voltage of a battery pack reaches a first threshold voltage, if yes, enter a working state, and if not, do not work.
S23: Determine whether the voltage of the battery pack is greater than or equal to a second threshold voltage, if yes, enter the working state, and if not, do not work.
S24: Determine whether the voltage of the battery pack drops to the first threshold voltage, if yes, stop working, and if not, maintain the working state.

In this embodiment, the automatic mower is enabled to be in a charging state as much as possible in the daytime, to fully use solar energy that can be received. This is particularly suitable for a scenario in which electric energy replenished by the solar panel for the battery pack in the daytime is less than an energy storage capacity of the battery pack. In this embodiment, the control module determines arrival of the nighttime, and more accurately, preferably enables the automatic mower to enter a working mode when determining that an illumination condition in a working area can no longer enable the solar panel to replenish the battery pack with electric energy. An energy storage capacity of the battery pack needs to satisfy a particular condition. Specifically, when the control module determines that the voltage of the battery pack is greater than the first threshold voltage, the control module controls the automatic mower to enter the working mode, and if the voltage of the battery pack drops to the first threshold voltage in a working process, the control module controls the automatic mower to exit the working mode. To be specific, in the nighttime, once the automatic mower is not in an undervoltage state (a to-be-charged state), the automatic mower can be enabled to enter the working mode. However, in the daytime, when an energy storage state of the battery pack is good, the automatic mower may alternatively enter the working mode. Specifically, when the voltage of the battery pack is greater than or equal to the second threshold voltage, the control module controls the automatic mower to enter the working mode. The second threshold voltage is greater than the first threshold voltage. Preferably, in the daytime, it is required that the automatic mower enters the working mode only when the battery pack is in a fully charged state.

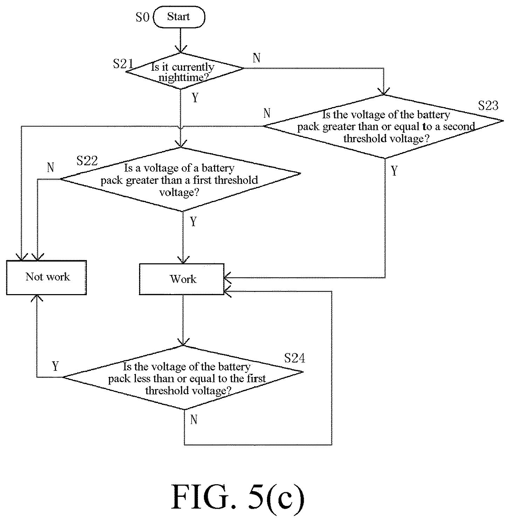

Refer to FIG. 5(c) for the workflow of this embodiment.

In this embodiment, in either the daytime or the nighttime, after the automatic mower exits the working mode, the automatic mower should move a location at which "an illumination condition is relatively good". In the daytime, the automatic mower moves to the location to be replenished with electric energy, and in the nighttime, the automatic mower moves to the location in advance, so as to be replenished with electric energy in time on arrival of the daytime. A method of replenishing the automatic mower with electric energy is similar to that in first embodiment. Details are not described again.

In the foregoing embodiments, the voltage of the battery pack is used as a parameter for measuring an energy storage state of the battery pack. It can be understood that another method for measuring the energy storage state of the battery pack may alternatively be used provided that whether the automatic mower needs to be charged can be determined.

In another embodiment of the present invention, a workflow of the automatic mower is basically the same as that in the first embodiment. This embodiment differs from the first embodiment in respect of formulating the workflow of the automatic mower according to a characteristic of a working area of the automatic mower and a relationship between an illumination situation and a time. The characteristic of the working area includes distribution characteristics and terrain characteristics of an open area and a shaded area in the working area. Specifically, according to a relationship in which illumination changes as a time changes in one day, the automatic mower is controlled to move and work at different locations in the working area in different time periods. For example, at midday, a time period when illumination intensity is relatively high, the automatic mower is controlled to move and work in an open area, and at nightfall, a time period when illumination intensity is relatively low, the automatic mower is controlled to move and work in an area in which shaded areas are relatively densely distributed, so that the automatic mower can use optical energy more effectively. A relationship between the illumination situation and the time may alternatively be determined in advance by obtaining weather forecast. According to illumination situations of different locations in different time periods in the working area, a location at which illumination intensity satisfies a working requirement in a current working area can be determined. Therefore, when the automatic mower needs to be replenished with electric energy, the automatic mower can be directly controlled to move a closest location at which illumination intensity satisfies the working requirement. Because illumination situations of different locations in different time periods in the working area can be determined in advance, a traveling path of the automatic mower can be formulated accordingly, so that the automatic mower is located at a particular location in the working area in a particular working time period. For example, a plurality of different paths can be drawn up. A working process of the automatic mower is simulated according to characteristics of the working area and a relationship between an illumination condition and a time, to determine cutting efficiency of the automatic mower in different paths and select a path in which cutting efficiency of the automatic mower is highest. The working area may alternatively be partitioned, so that the automatic mower moves and works in different sub-working areas in different time periods.

Working plans of the automatic mower mentioned in the foregoing embodiments are all formulated or adjusted based on illumination condition information of the working area. The "illumination condition information of the working area" mentioned herein means an illumination condition situation of the whole working area in a specific time period. For example, the sunny day or the rainy day represents different illumination condition information. For another example, the daytime or nighttime further includes midday or nightfall, and the like.

The illumination condition information of the working area includes weather information. In one of the embodiments, the automatic mower includes a communications module, configured to obtain weather information through the Internet. The weather information may include total low cloud amount information, illumination intensity information, and the like. For example, an total low cloud amount of a cloudy day is 8/10 or above. The control module formulates or adjusts a working plan based on weather information, and for example, controls the automatic mower to not work in a rainy day or adjusts a voltage at which the automatic mower needs to be replenished with electric energy, that is, the first threshold voltage mentioned above, when a rainy day is about to arrive.

The illumination condition information of the working area further includes time period information in one day. In one of the embodiments, the automatic mower includes a clock module, configured to output a current moment. The control module formulates or adjusts a working plan based on time period information of the current moment. For example, the automatic mower is controlled to preferably work in the nighttime, or a working plan of the automatic mower at midday is adjusted, and so on.

The illumination condition information of the working area further includes current illumination intensity information. In an embodiment, the automatic mower includes an illumination sensor, configured to output illumination intensity information currently received by the automatic mower. It should be noted that an output voltage of the solar panel can be used as a parameter for measuring illumination intensity. The control module formulates or adjusts a working plan based on the current illumination intensity information, and for example, adjusts a charging location according to the current illumination intensity information or changes a working plan according to the current illumination intensity information.

Further, the control module formulates or adjusts a working plan of the automatic mower according to a relationship between illumination intensity corresponding to illumination condition information and a preset illumination intensity threshold. The illumination intensity threshold is not necessarily stored in a form of an illumination intensity value, and preset information representing illumination intensity may be preset by the control module. When the illumination condition information received by the control module and the preset information presenting illumination intensity satisfy a specific relationship, it is considered that illumination intensity corresponding to the illumination condition information and the preset illumination intensity threshold satisfy a specific relationship. For example, the control module presets a time period that is determined as nighttime to last from 18:00 pm to 6:00 am. It can be understood that an objective relationship exists between the illumination condition information and the illumination intensity. In the time period from 18:00 am to 6:00 am, the illumination intensity is less than or equal to a specific value, and for example, is less than or equal to 1 (lux). If the current moment received by the control module is 15:00 pm, the control module determines that a time period to which the current moment belongs is not from 18:00 pm to 6:00 am. Correspondingly, illumination intensity at 15:00 pm is necessarily greater than a specific value, for example, is greater than 5 (lux), and is greater than an illumination intensity threshold corresponding to a time period that is determined to be nighttime. The control module directly determines, based on a relationship between a time period to which a current moment belongs and a preset time period, a relationship between current illumination intensity and a preset illumination intensity threshold, to match a working plan of the automatic mower with illumination intensity.

The preset information representing illumination intensity may alternatively be a output voltage of the solar panel, a total low cloud amount, or the like. Certainly, the control module may alternatively directly obtain a currently received illumination intensity value by using an illumination sensor, and compare the illumination intensity value with a preset value, to formulate or adjust a working time plan.

In the second embodiment of the present invention, when the illumination intensity corresponding to the illumination condition information is less than or equal to a first illumination intensity threshold, the control module determines that it is nighttime currently, and when the illumination intensity corresponding to the illumination condition information is greater than the first illumination intensity threshold, the control module determines that it is daytime currently. The control module may perform determining according to output of the clock module, and the first illumination intensity threshold corresponds to a maximum of illumination intensity in a time period of nighttime, for example, from 18:00 pm to 6:00 am. The control module may alternatively perform determining according to a voltage value output by the solar panel, and the first illumination intensity threshold corresponds to an illumination intensity threshold when the output voltage of the solar panel is less than or equal to, for example, 8 V, and so on.

In the first and/or second embodiment of the present invention, the control module adjusts, based on the illumination condition information of the working area, a condition on which the automatic mower needs to be replenished with electric energy, and specifically, adjusts a value of the first threshold voltage (hereinafter referred to as an undervoltage) of the battery pack. Particularly, the control module adjusts, based on a season model of the working area, a condition on which the automatic mower needs to be replenished with electric energy.

Rainy day data of different areas differs in different seasons. When a duration of rainy days is relatively long in the working area, the automatic mower cannot be replenished with electric energy for a long time. A remaining capacity of the battery pack needs to maintain a standby state of the automatic mower in a long time, to prevent overdischarging of the battery pack from affecting a service life of the battery pack. Therefore, when a duration of rainy days is relatively long in the working area, an undervoltage value of the battery pack should be properly raised by adjustment. Specifically, the automatic mower includes a storage unit, configured to store a season model parameter, and the season model parameter includes illumination condition information of different regions and different time periods; and the control module receives a geographic location and date information, and obtains the season model parameter based on the received geographic location and date information, so as to determine illumination condition information of the working area in a current time period. A value of the first threshold voltage of the battery pack is increased as a time period in which the illumination intensity reflected by the illumination condition information is maintained to be less than or equal to a first illumination intensity threshold is increased. The first illumination intensity threshold corresponds to an illumination intensity threshold of a rainy day. A standard the same as that of determining nighttime may be used herein. The rainy day and nighttime have a same attribute, that is, the automatic mower cannot be replenished with electric energy by using the solar panel. Specifically, an output voltage of the solar panel is less than or equal to, for example, 8 V. Certainly, the "first illumination intensity threshold" herein may alternatively be a standard different from that of determining nighttime, and only a same expression is used. In this embodiment, a method for adjusting an undervoltage value according to a season model parameter includes the following steps: a) Obtain a country to which a current working area belongs. Specifically, an input module is configured for the automatic mower, and a user inputs or selects, according to a selection list, a country to which a current working area belongs. Alternatively, a country to which a current working area belongs is automatically recognized according to a positioning result. b) Query a database according to country information, to obtain a season model parameter of the country to which the current working area belongs. The database is stored in the storage module and includes season model parameters corresponding to different countries. The season model parameter includes average or maximum rainy day data of different seasons. c) Obtain a current date. d) Determine a current season according to the current date, and obtain a current season model parameter. e) Adjust an undervoltage value according to the current season model parameter.

Formulation and adjustment of a working plan of an automatic mower and a relationship between the working plan and illumination condition information of a working area are mentioned throughout the description, and are not limited to the explanation herein.

In a process of controlling moving and working of the automatic mower, it is necessary to recognize a location at which an illumination condition is relatively good in the working area. The location at which an illumination condition is relatively good is preliminarily determined as a location at which illumination intensity satisfies a preset condition. Illumination intensity satisfying a preset condition is a determining standard that is set for ensuring that the illumination intensity can provide energy required for normal moving and working of the automatic mower. Relatively simple determining may be considered to be that illumination intensity in an open area that is not shaded in a sunny day can satisfy preset condition. Relatively specific determining may be considered to be that illumination intensity that can enable the output voltage of the solar panel to reach a preset value can satisfy a preset condition.

There are various methods for recognizing a location at which an illumination condition is relatively good in a working area.

One of the methods is storing a map of the working area in the storage module, recognizing a location at which an illumination condition is relatively good in the map, and marking the location. An illumination condition of a location of the automatic mower can be determined by obtaining, by comparison, a relationship between the location of the automatic mower and the stored location at which an illumination condition is relatively good. When a distance between the automatic mower and the location at which an illumination condition is relatively good is shorter than a preset distance, it is considered that an illumination condition at the location of the automatic mower is relatively good. Certainly, in this method, alternatively, a location of a shaded area may be marked in advance in the map. Establishment of a map and comparison for a location relationship may be implemented by satellite positioning and establishing a coordinate system, or may be implemented by using a method such as capturing an image with a camera or setting an RFID tag.

In the first and/or second embodiment of the present invention, before the automatic mower starts working, an illumination map of the working area is established. Specifically, in this embodiment, the control module receives positioning information at one or more locations of the automatic mower when the automatic mower moves in the working area, receives illumination intensity information at one or more locations of the automatic mower when the automatic mower moves in the working area, and generates an illumination map of the working area based on the received positioning information and illumination intensity information. To be specific, the illumination map stores positioning information at one or more locations in the working area and corresponding illumination intensity information. The illumination intensity information, as described above, may be obtained selectively by an illumination sensor, by estimating an output voltage of the photoelectric conversion unit/solar panel, by estimating strength of a satellite positioning signal, or the like. In this embodiment, the control module estimates an illumination intensity level at one or more locations of the working area based on the received illumination intensity information. The illumination intensity level may be a level of illumination intensity. For example, light intensity that is above 10⁵ lux is defined as high intensity. In a moving process of the automatic mower, the control module may determine whether a current location of the automatic mower corresponds to the positioning information at the one or more locations stored in the illumination map, and if yes, an illumination intensity level of the current location of the automatic mower may be determined according to a correspondence between the positioning information and the illumination intensity information. The illumination map may perform fitting on illumination intensity between adjacent locations according to geographic continuity.

In this embodiment, the control module further receives attitude information at one or more locations of the automatic mower when the automatic mower moves in the working area, and the illumination map records the attitude information. When the automatic mower is on different attitudes, angles at which solar illumination radiation is received by the solar panel are different, so that different illumination intensity information is received by the automatic mower on different attitudes. The attitude information may be obtained by mounting an attitude sensor on the automatic mower and detecting output of the attitude sensor such as a gyroscope or a compass. A traveling direction of the automatic mower may alternatively be fitted by using the traveling path of the automatic mower, to determine an attitude of the automatic mower.

In this embodiment, the illumination map includes a time dimension. Specifically, the control module records a time period in which the positioning information and the corresponding illumination intensity information are received, to generate a time-based illumination map. Because the sun rises in the east and sets in the west, in different time periods in one day, different illumination intensity is received at a same location in the working area. Particularly, a shaded location in the working area moves a solar position moves. Therefore, to obtain a more accurate illumination map, it is necessary to associate illumination intensity at different locations in the working area with time, so that the illumination map is constructed to be a dynamic map that changes with time. In this way, when the automatic mower moves and works, the automatic mower first determines a time period to which a current moment belongs in one day, and then determines a relationship between a location in the working area and illumination intensity in the current time period, so that the automatic mower more accurately determines an illumination intensity level at a current location. This is also beneficial to quickly finding, by the automatic mower, a location at which illumination intensity is high in the working area.

In this embodiment, the automatic mower includes a charging mode, and when the automatic mower enters the charging mode, the control module controls the automatic mower to move, based on the illumination map, to a location at which illumination intensity satisfies a preset level (for example, light intensity is greater than 10⁵ lux) to be replenished with electric energy. A meaning of the location at which illumination intensity satisfies a preset level is similar to a meaning of the "location at which an illumination condition is relatively good". The location at which illumination intensity satisfies a preset level is referred to as a charging point, and several charging points are recorded in the illumination map. In this embodiment, the control module determines whether the automatic mower needs to enter a charging mode by comparing a voltage of the battery pack with a threshold voltage. Specifically, when determining that the voltage of the battery pack is less than or equal to a first threshold voltage, the control module controls the automatic mower to enter the charging mode. In another embodiment, whether the automatic mower needs to enter the charging mode may alternatively be determined by detecting another parameter. In this embodiment, when the automatic mower enters the charging mode, the control module controls the automatic mower to move a closest charging point to be replenished with electric energy. Further, the control module plans a shortest path along which the automatic mower moves to the closest charging point, and the automatic mower moves to the closest charging point according to the shortest path. If the closest charging point does not satisfy a charging requirement (for example, light intensity does not reach 10⁵ lux), the automatic mower moves to a location of a next closest charging point until a location satisfy the charging requirement is found. In this embodiment, when the automatic mower moves, the control module estimates a distance between a current location of the automatic mower and a charging point, and adjusts a value of the first threshold voltage based on the distance between the current location of the automatic mower and the charging point, particularly, based on a distance between the current location of the automatic mower and a closest charging point, so that the value of the first threshold voltage is increased as the distance increases, to ensure that the battery pack has sufficient remaining energy supplied for the automatic mower to move to the charging point to be replenished with electric energy.

In this embodiment, after the automatic mower exits the charging mode, the control module controls the automatic mower return to an expected location, and the expected location includes a location through which the automatic mower moves before the automatic mower enters the charging mode. Specifically, the automatic mower may return to a location at which the automatic mower enters the charging mode. If the automatic mower moves along a preset path, the automatic mower may return to a specific location through which automatic mower moves along the preset path before the automatic mower enters the charging mode. The automatic mower is enabled to return to the expected location, so that cutting work of the automatic mower has continuity, thereby avoiding a problem that cutting is not performed in some areas. If the automatic mower moves according to a preset path, after exiting the charging mode, the automatic mower may alternatively directly arrive at a specific location that is closest to a charging point and that is in the preset path, and after completing traversal along the preset path, the automatic mower further returns to a location at which the automatic mower enters the charging mode, to complete cutting work in an uncovered area. In this embodiment, when determining that the voltage of the battery pack is greater than or equal to a second threshold voltage, the control module controls the automatic mower to exit the charging mode. The second threshold voltage is greater than first threshold voltage.

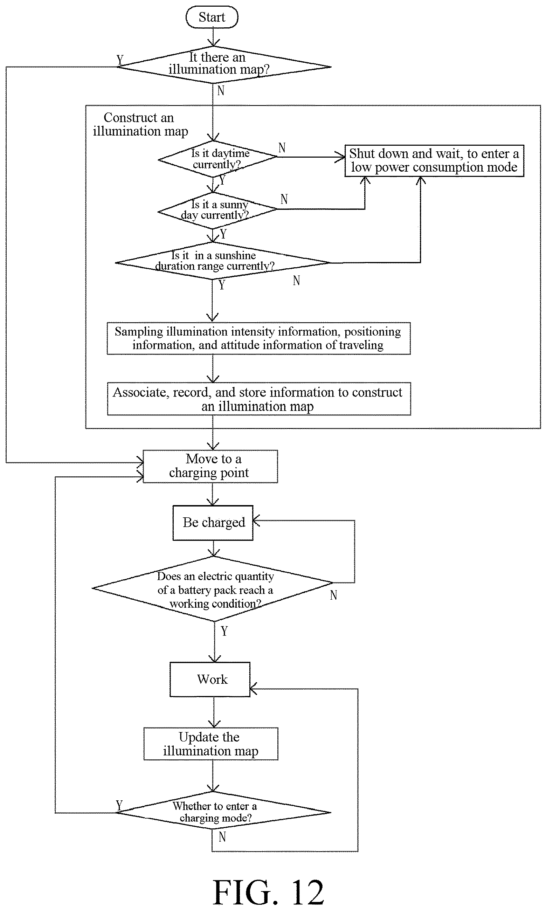

Refer to FIG. 12 for construction of the illumination map and a charging process. In this embodiment, the illumination map may alternatively be updated at intervals, or the map is updated in real time in a process in which the automatic mower moves and works, to obtain a more accurate time-based illumination map.

A location at which an illumination condition is relatively good in the working area may alternatively be recognized without establishing an illumination map of the working area. In a third embodiment of the present invention, an automatic mower includes an illumination intensity detection unit, configured to receive illumination intensity information, where a control module determines an illumination intensity level at a current location of the automatic mower based on the illumination intensity information received by the illumination intensity detection unit. The illumination intensity detection unit may include an illumination sensor, a photoelectric conversion unit output voltage detection module, or a satellite positioning signal receiving module. Details are provided below:
In one of the embodiments, the automatic mower determines an illumination condition at a location of the automatic mower by using a satellite positioning signal. Usually, in an open area, a signal received by a satellite positioning apparatus is relatively strong, and an illumination condition is also relatively good. In a shaded area, a signal received by the satellite positioning apparatus is relatively weak, and an illumination condition is also relatively poor. Therefore, illumination intensity at a location of the automatic mower may be determined by determining strength of a signal received by the satellite positioning apparatus.

In another one of the embodiments, the automatic mower determines an illumination condition at a location of the automatic mower by using the illumination sensor. The illumination sensor can directly sense illumination intensity and output a signal reflecting the illumination intensity to the control module.

In another one of the embodiments, the control module detects an output voltage of the photoelectric conversion unit, and specifically, detects an output voltage of the solar panel. A higher output voltage of the solar panel reflects that an illumination intensity level at a current location is higher.

When the automatic mower enters the charging mode, the control module determines whether illumination intensity at a current location of the automatic mower satisfies a preset level, if yes, controls the automatic mower to stay at the location to be charged, and if not, controls the automatic mower to move to find a location at which illumination intensity satisfies a preset level. The control module determines, based on output of the illumination intensity detection unit, whether illumination intensity at a location through the automatic mower moves satisfies a preset level, and if yes, controls the automatic mower to stay at the location to be charged.

In the first and/or second embodiment of the present invention, when the automatic mower is in the charging mode, the control module controls the automatic mower to change, at a location, an angle at which the photoelectric conversion unit receives optical energy, and the control module determines an optimal angle of the photoelectric conversion unit for receiving optical energy, and controls a receiving angle of the photoelectric conversion unit to be at least temporarily maintained at the optimal angle. The optimal angle of the photoelectric conversion unit for receiving optical energy is an angle at which the received illumination intensity level reaches a maximum or an angle at which a receiving area is largest. Specifically, when determining that the automatic mower needs to be replenished with electric energy, the control module first controls the automatic mower to find a location at which illumination intensity satisfies a preset level, and controls the automatic mower to rotate after determining that the automatic mower is located at a location at which illumination intensity satisfies a preset level. Because the solar panel is usually disposed at a specific angle to the housing (for example, 0 to 60 degrees), and a change of an attitude of the automatic mower leads to a change of an angle at which the solar panel receives illumination radiation. When the solar panel receives illumination radiation at different angles, the received illumination intensity levels are different, and are specifically reflected by changes of the output voltage of the solar panel. In a process in which the automatic mower rotates, the control module estimates an output voltage of the solar panel, and determines an attitude of the automatic mower when the output voltage of the solar panel relatively reaches a maximum, to maintain the automatic mower on the attitude to be charged. In a variant implementation, the solar panel may be enabled to rotate relative to the housing, to change an angle at which the solar panel receives illumination radiation, and its effect is equivalent to an effect when the automatic mower rotates. Certainly, alternatively, if an illumination map including an attitude of the automatic mower is stored in advance, the attitude of the automatic mower or the charging panel may be directly adjusted according to the illumination map.

Because the sun rises in the east and sets in the west, and a solar position moves, after the charging panel is maintained on a specific attitude to be charged for a period of time, the attitude of the charging panel needs to be adjusted again, to enable an illumination radiation angle to reach an optimal angle. An time interval of adjustment may be 15 minutes or half an hour.

In a case, after the automatic mower moves to a charging point, the control module determines, for example, based on output of the illumination sensor or an output voltage of the photoelectric conversion unit/the solar panel, that illumination intensity at a current location does not satisfy a charging requirement. A reason of such a case may be that the automatic mower is located in a shaded area. The shaded area may be formed by a building, a tree, or the like, or a change of a solar position, or a temporary or dynamic obstacle. A reason of such a case may be that positioning precision is not high, a deviation exists between a location at which the automatic mower arrives and an actual location of the charging point. In this case, after the automatic mower moves to a "charging point", the automatic mower may move or rotate within a small scope to seek for a location at which illumination intensity satisfies a charging requirement, for example, rotate in a specific radius.

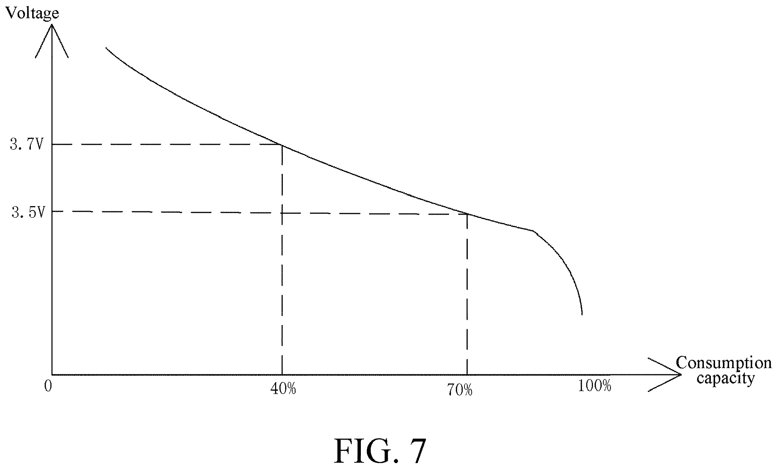

In the first and/or second embodiment of the present invention, a control policy of the automatic mower may be adjusted according to a change of an illumination condition. Specifically, the control module may adjust a value of the first threshold voltage or the second threshold voltage according to a current illumination condition. In a process in which the automatic mower moves and works, the automatic mower is not always in an area in which illumination intensity is relatively good, and when the automatic mower is located in a shaded area, the solar panel cannot receive optical energy and cannot effectively convert optical energy into electric energy. A sunshine duration of the working area is limited, and illumination intensity always reaches a peak value at midday, and at this time, power supply efficiency of the solar panel is highest. Therefore, at midday when the illumination intensity reaches the peak value, the automatic mower should be located in an open area as much as possible. In this embodiment, in a time period in which illumination intensity is relatively high, a value of the first threshold voltage of the battery pack is increased, so that a probability that the automatic mower is located in an open area in the time period is increased. Specifically, the first threshold voltage of the battery pack in a normal state is 17.5 V, and in a time period in which the illumination intensity is relatively high, a value of the first threshold voltage is adjust to 18.5 V. When the automatic mower works in a normal working time period, when the control module detects that the voltage of the battery pack is less than or equal to 17.5 V, the control automatic mower moves to a location at which an illumination condition is relatively good. It could be learned from a discharging characteristic curve of a lithium battery (as shown in FIG. 7) that a remaining capacity of the battery pack is approximately 30% of a capacity of the battery pack when the battery pack is fully charged. If the automatic mower is already located in an open area, the automatic mower is controlled to stay in the open area to wait for being charged, and if the automatic mower is located in a shaded area, the automatic mower is controlled to move to an open area to be charged. When the control module determines that it is currently a time period in which illumination intensity is relatively high, when the control module detects that the voltage of the battery pack is less than or equal to 18.5 V, the automatic mower is controlled to move to a location at which an illumination condition is relatively good. It could be learned from a discharging characteristic curve of a lithium battery that a remaining capacity of the battery pack is approximately 60% of a capacity of the battery pack when the battery pack is fully charged. The charging apparatus of the automatic mower is enabled to more fully use illumination by increasing a value of the first threshold voltage of the battery pack in a time period in which illumination intensity is relatively high, so as to provide sufficient energy for moving and working of the automatic mower.

Certainly, in another embodiment, the value of the first threshold voltage may alternatively be adjusted to another value, and the value may alternatively change stepwise according to a change of illumination intensity.

In the first and/or second embodiment of the present invention, determining that it is currently in a time period in which illumination intensity is relatively high may be implemented by using a clock unit, detecting a voltage of the solar panel, obtaining external information (for example, an instruction of a user) through a wireless communications apparatus, or by presetting the automatic mower. A user may even alternatively manually adjust a threshold voltage of the battery pack on the automatic mower or in a remotely controlling manner.

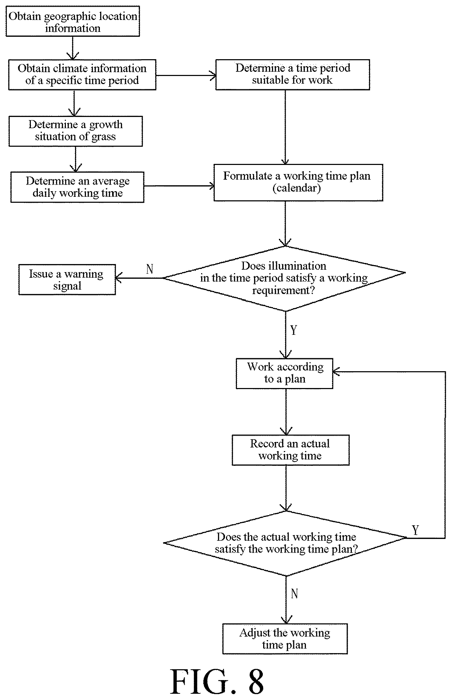

In this embodiment, the automatic mower includes a wireless communications apparatus. The automatic mower may receive climate information, including weather forecast, illumination intensity information, and the like, through the wireless communications apparatus based on positioning of a positioning apparatus. On the one hand, the automatic mower may learn of a grass growth situation according to the climate information, so as to formulate a proper working plan, for example, determine an average daily working time. On the other hand, the automatic mower may determine a time period suitable for work according to the weather forecast and the illumination intensity information. The automatic mower may formulate a working time plan and form a calendar according to the foregoing information. Information of the calendar includes that in a specific day or a specific time period, the automatic mower works, and in another time period, the automatic mower does not work. The automatic mower may alternatively record an actual working time, compare it with a working plan, determine whether work of the automatic mower satisfies the plan, and adjust the working time plan if the work of the automatic mower does not satisfy the plan. If the automatic mower finds that in a specific time period (for example, in a specific month), the optical energy received by the solar panel cannot satisfy a demand of the automatic mower for maintaining a lawn, the automatic mower may send a warning signal to prompt the user, and the warning signal may be issued on the body of the automatic mower, and may alternatively be sent through a wireless communications apparatus to an intelligent terminal of a user. An application used to manage the charging apparatus of the automatic mower is set on the intelligent terminal of the user, so that the user can check information related to a working situation and an illumination condition, and manually adjust the working time plan. A process of formulating a working time of an automatic working system is shown in FIG. 8.

In the first and/or second embodiment of the present invention, the storage module of the automatic mower stores a preset path mode. The control module controls the automatic mower to move in the preset path mode. Moving, by the automatic mower, in the preset path mode can improve an effective coverage ratio λ of the automatic mower. Specifically, a ratio of an area of the working area to an area of an area through the automatic mower passes to completely cover the working area is referred to as an effective coverage ratio of the automatic mower in a specific preset path mode. A path formed by moving, by the automatic mower, in the preset path mode includes a parallel path, a spiral path, or the like. In this embodiment, an effective coverage ratio of the automatic mower in the preset path mode is greater than or equal to 0.6. Improving the effective coverage ratio of the automatic mower can save power consumed by the automatic mower. If effective working electric energy received by the energy consumption device from the photoelectric conversion unit is limited, saving power consumed by the automatic mower provides a guarantee for satisfying that the photoelectric conversion unit supplies power for moving and working of the automatic mower. An effective coverage ratio of the automatic mower in a random traveling mode is approximately 0.2. Certainly, the effective coverage ratio may alternatively be increased by using a method of partitioning an area for working.

An effective coverage ratio λ, battery pack charging efficiency β, a battery pack discharging utilization ratio σ, and the like are all impact factors affecting whether the photoelectric conversion unit can provide sufficient electric energy for moving and working of the automatic mower. When whether the photoelectric conversion unit can provide sufficient electric energy for moving and working of the automatic mower is estimated, power generation efficiency of the solar panel may alternatively be considered. The power generation efficiency of the solar panel is related to a mounting angle of the solar panel, an orientation of the solar panel, surface transmittance, a load matching degree, and the like. In the foregoing embodiments, the power generation efficiency of the solar panel, the battery pack charging efficiency β, the battery pack discharging utilization ratio σ, and the like have been taken into consideration in the coefficient of efficiency γ.

When the battery pack is charged, a temperature may be relatively high. When a protection temperature is reached, it is necessary to disable a charging function, and consequently, the battery pack cannot be charged. To avoid the foregoing problem, in this embodiment, the automatic mower includes a temperature control device, configured to reduce a temperature in a periphery of the battery pack periphery. Specifically, the temperature control device includes a container, configured to hold a cooling solvent and disposed in the periphery of the battery pack, to absorb heat of the battery pack. Alternatively, the temperature control device includes a fan, configured to form an airflow flowing from the battery pack to the outside of the housing, to help the battery pack to dissipate heat. Alternatively, the temperature control device includes a heat insulation component, for example, a high-temperature-resistant heat insulation plate, disposed in the periphery of the battery pack to insulate heat of the battery pack.

When dust is accumulated on a surface of the charging pane, photoelectric conversion efficiency of the charging panel is affected. To avoid the foregoing problem, in this embodiment, the control module generates or receives a cleaning request signal of the charging panel and generates a cleaning warning signal in response to the cleaning request signal. In an implementation, the automatic mower includes a timer. A cleaning cycle is preset. The timer starts timing from completion of cleaning of the charging panel last time and sends the cleaning request signal to the control module when the cleaning cycle expires. In another implementation, the control module determines whether the effective working electric energy received by the energy consumption device from the photoelectric conversion unit decreases, and generates a cleaning request signal if the effective working electric energy decreases and reaches a threshold. Specifically, during charging, a power generation amount of the solar panel is detected. A time period is selected. For example, power generation amounts in a time period to which 12:00 am at midday belongs are detected. If a power generation amount of a time period to which 12:00 am at midday belongs in one day is lower than an average value of power generation amounts in the time period to which 12:00 am at midday belongs everyday in a previous period of time (for example, a week) by a specific preset threshold, and the current weather is not a rainy day, a cleaning request signal is generated. Certainly, determining may alternatively be performed by detecting an output voltage of the solar panel at a specific moment. The cleaning request signal includes an optical signal, such as an indicator, a sound signal, or prompt information sent to a user terminal, to issue a prompt through an APP.

In this embodiment, the automatic mower includes an electric quantity indication apparatus, configured to indicate a charging state and an electric quantity level of the battery pack.

In another embodiment of the present invention, the automatic working system includes an automatic mower, a fixed charging station, or the like. Specifically, the automatic working system includes a first charging apparatus and a second charging apparatus. The first charging apparatus, as described above, is disposed on the automatic mower and configured to use the photoelectric conversion unit to convert optical energy into electric energy. The battery pack stores the electric energy, to provide energy for moving and working of the automatic mower. The second charging apparatus is a fixed charging station, and when the automatic mower is docked with the charging station, the charging station charges the battery pack. When determining that a illumination situation in a specific time period cannot satisfy a demand of the automatic mower for maintaining a lawn, the control module controls the automatic mower to move to the charging station to be replenished with electric energy. A solar panel may be mounted on the second charging apparatus, to be solar-powered.

As shown in 9, in another embodiment of the present invention, the automatic mower further includes a bird scaring apparatus 15. Specifically, the bird scaring apparatus 15 is an ultrasonic apparatus. Preferably, the bird scaring apparatus 15 is disposed on the solar panel or nearby the solar panel. A signal issued by the bird scaring apparatus 15 prevents a bird from staying nearby, to protect the solar panel.

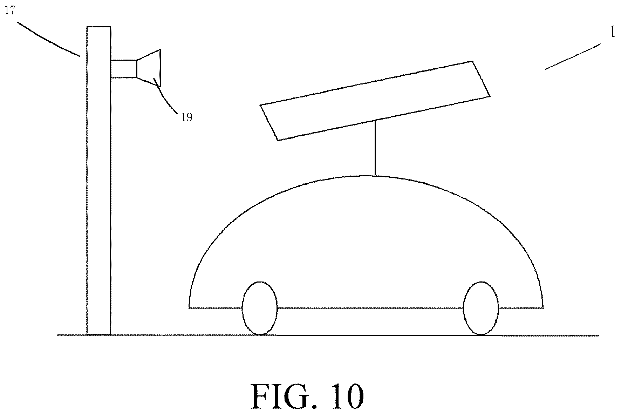

As shown in FIG. 10, in another of the present invention, the automatic working system further includes a cleaning apparatus 17, configured to clean a surface of the solar panel, so that the solar panel maintains photoelectric conversion efficiency of a high level. The cleaning apparatus 17 is fixed in the working area, and the control module can control the automatic mower to move to the cleaning apparatus and trigger the cleaning apparatus to clean the solar panel. The cleaning apparatus includes a cleaning head 19. Specifically, the cleaning head 19 may be a cleaning brush. When the self-moving device approaches the cleaning apparatus, the cleaning brush brushes out dust on the surface of the solar panel by using a relative displacement between the self-moving device and the cleaning apparatus. The cleaning apparatus may alternatively be a spraying apparatus or an air blowing apparatus. When the automatic mower moves to the cleaning apparatus, the cleaning apparatus is triggered to automatically clean the solar panel.

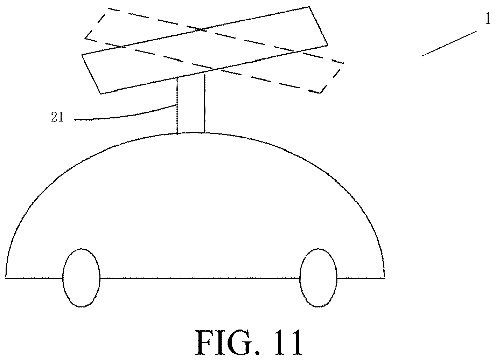

As shown in FIG. 11, in another embodiment of the present invention, the solar panel is connected to the body of the automatic mower through a connection mechanism 21. The connection mechanism 21 can actuate the solar panel to rotate, to adjust an attitude of the solar panel. The control module controls, according to an illumination situation, particularly, according to a direct solar radiation angle, the connection mechanism 21 to actuate the solar panel to rotate, so that a receiving angle of the solar panel is always an angle at which the solar panel is subject to direct solar radiation, thereby improving photoelectric conversion efficiency.

In another embodiment of the present invention, the automatic working system includes a boundary line, used to define a scope in which the automatic mower moves and works. A boundary line transmission signal generator issues an electric signal and generates an electromagnetic field. The automatic mower includes only one boundary sensor, configured to detect a boundary signal. The control module determines, according to the boundary signal detected by the boundary sensor, whether the automatic mower moves to a boundary, so as to control the automatic mower to move and work in a working area defined by the boundary line. In this embodiment, the automatic mower does not need to return to the charging station along the boundary line to be replenished with electric energy. Therefore, a working requirement of the automatic mower can be satisfied by one boundary sensor.

The present invention is not limited to the specific embodiments listed, and structures and methods based on the idea of the present invention all fall within the protection scope of the present invention.

The present disclosure can be described further with the following clauses:
1. An automatic working system, comprising: a self-moving device, configured to move and work in a working area, wherein the self-moving device comprises a housing, a moving module, and a control module, and the control module controls the moving module to actuate the self-moving device to move;
   the self-moving device comprises an energy consumption device, wherein the energy consumption device comprises a device that consumes energy for actuating the self-moving device to move and work; and
   the self-moving device further comprises:
   a photoelectric conversion unit, wherein the photoelectric conversion unit receives optical energy and converts the received optical energy into electric energy; and
   an energy storage unit, configured to store the electric energy obtained by conversion by the photoelectric conversion unit,
   wherein
   effective working electric energy that is received by the energy consumption device from the photoelectric conversion unit and that is converted by the photoelectric conversion unit is greater than or equal to energy consumed by the energy consumption device to actuate the self-moving device to move and work.
2. The automatic working system according to clause 1, wherein photoelectric conversion efficiency of the photoelectric conversion unit is greater than or equal to 0.12.
3. The automatic working system according to clause 1, wherein the photoelectric conversion unit comprises monocrystalline silicon or polycrystalline silicon.
4. The automatic working system according to clause 1, wherein the self-moving device comprises a charging panel for mounting the photoelectric conversion unit, disposed on the housing, wherein density of the charging panel is less than or equal to 10 kg/m².
5. The automatic working system according to clause 1, wherein the self-moving device comprises a charging panel for mounting the photoelectric conversion unit, disposed on the housing, the charging panel comprises a protection layer covering a surface of the photoelectric conversion unit, and the protection layer is made from an epoxy glue.
6. The automatic working system according to clause 1, wherein an area of the photoelectric conversion unit is greater than or equal to a projected area of the housing of the self-moving device on a working plane.
7. The automatic working system according to clause 1, wherein the self-moving device comprises a charging panel for mounting the photoelectric conversion unit, disposed on the housing, and the charging panel is formed with an outer contour fitting the housing.
8. The automatic working system according to clause 1, wherein when a voltage of the energy storage unit is less than or equal to a first threshold voltage, the control module controls the self-moving device to stop working until the voltage of the energy storage unit is greater than or equal to a second threshold voltage, and the second threshold voltage is greater than or equal to the first threshold voltage.
9. The automatic working system according to clause 8, wherein the photoelectric conversion unit has a maximum power point voltage, and the maximum power point voltage is an output voltage of the photoelectric conversion unit when a conversion power of the photoelectric conversion unit reaches a maximum; and a ratio of a difference between the first threshold voltage or the second threshold voltage and the maximum power point voltage to the maximum power point voltage is not greater than 0.2.
10. The automatic working system according to clause 8, wherein the self-moving device comprises a charging management unit, and the charging management unit comprises a voltage converter; the photoelectric conversion unit has a maximum power point voltage, and the maximum power point voltage is an output voltage of the photoelectric conversion unit when a conversion power of the photoelectric conversion unit reaches a maximum; and the voltage converter is electrically connected between the photoelectric conversion unit and the energy storage unit, to enable the output voltage of the photoelectric conversion unit to be maintained at the maximum power point voltage.
11. The automatic working system according to clause 1, wherein the self-moving device further comprises a positioning module, configured to output positioning information of the self-moving device.
12. The automatic working system according to clause 11, wherein the control module receives positioning information at one or more locations of the self-moving device when the self-moving device moves in the working area, receives illumination intensity information at one or more locations of the self-moving device when the self-moving device moves in the working area, and generates an illumination map of the working area based on the received positioning information and illumination intensity information.
13. The automatic working system according to clause 12, wherein the self-moving device comprises an illumination sensor, and the illumination intensity information received by the control module is output from the illumination sensor.
14. The automatic working system according to clause 12, wherein the illumination intensity information received by the control module is obtained by estimating an output voltage of the photoelectric conversion unit.
15. The automatic working system according to clause 12, wherein the positioning module receives a satellite positioning signal, and the illumination intensity information received by the control module is obtained by estimating intensity of the satellite positioning signal.
16. The automatic working system according to clause 12, wherein the control module further receives attitude information at one or more locations of the self-moving device when the self-moving device moves in the working area, and the illumination map records the attitude information.
17. The automatic working system according to clause 16, wherein the self-moving device comprises an attitude sensor, and the attitude information received by the control module is output from the attitude sensor.
18. The automatic working system according to clause 12, wherein the control module records a time period of receiving the positioning information and the corresponding illumination intensity information, and generates the illumination map that is based on time.
19. The automatic working system according to clause 12, wherein the control module estimates an illumination intensity level at one or more locations of the working area based on the received illumination intensity information; and the self-moving device comprises a charging mode, and when the self-moving device enters the charging mode, the control module controls the self-moving device to move, based on the illumination map, to a location at which illumination intensity satisfies a preset level to be replenished with electric energy.
20. The automatic working system according to clause 19, wherein when the self-moving device enters the charging mode, a location at which illumination intensity satisfies the preset level and that is closest to a current location is determined, and the self-moving device is controlled to move to the location to be replenished with electric energy.
21. The automatic working system according to clause 19, wherein when determining that a voltage of the energy storage unit is less than or equal to the first threshold voltage, the control module controls the self-moving device to enter the charging mode.
22. The automatic working system according to clause 21, wherein when the self-moving device moves, the control module estimates a distance between a current location of the self-moving device and a location at which illumination intensity satisfies the preset level, and adjusts a value of the first threshold voltage based on the distance, wherein the value of the first threshold voltage increases as the distance increases.
23. The automatic working system according to clause 19, wherein after the self-moving device exits the charging mode, the control module controls the self-moving device to return to an expected location, and the expected location comprises a location through which the self-moving device moves before the self-moving device enters the charging mode.
24. The automatic working system according to clause 23, wherein when determining that the voltage of the energy storage unit is greater than or equal to a second threshold voltage, the control module controls the self-moving device to exit the charging mode.
25. The automatic working system according to clause 1, wherein the self-moving device comprises an illumination intensity detection unit, configured to receive illumination intensity information, and the control module determines an illumination intensity level at a current location of the self-moving device based on the illumination intensity information received by the illumination intensity detection unit; and the self-moving device comprises a charging mode, and when the self-moving device enters the charging mode, the control module determines an illumination intensity level at a current location of the self-moving device, and controls the self-moving device to stay at or moves to a location at which illumination intensity satisfies a preset level to be replenished with electric energy.
26. The automatic working system according to clause 25, wherein the illumination intensity detection unit comprises an illumination sensor, a photoelectric conversion unit output voltage detection module, or a satellite positioning signal receiving module.
27. The automatic working system according to clause 1, wherein the self-moving device comprises a charging mode, and in the charging mode, the control module controls the self-moving device to change, at a location, an angle at which the photoelectric conversion unit receives optical energy, and the control module determines an optimal angle of the photoelectric conversion unit for receiving optical energy, and controls a receiving angle of the photoelectric conversion unit to be at least temporarily maintained at the optimal angle.
28. The automatic working system according to clause 1, wherein the control module receives illumination condition information of the working area, formulates or adjusts a working plan of the self-moving device based on the illumination condition information of the working area, and controls the self-moving device to carry out the working plan.
29. The automatic working system according to clause 28, wherein the self-moving device comprises a communications module, configured to obtain weather information through the Internet; and the illumination condition information of the working area comprises the weather information, and the control module formulates or adjusts the working plan based on the weather information.
30. The automatic working system according to clause 29, wherein the weather information comprises total low cloud amount information or illumination intensity information.
31. The automatic working system according to clause 28, wherein the self-moving device comprises a clock module, configured to output a current moment; and the illumination condition information of the working area comprises time period information in one day, and the control module formulates or adjusts the working plan based on time period information of the current moment.
32. The automatic working system according to clause 28, wherein the self-moving device comprises an illumination sensor, configured to output illumination intensity information currently received by the self-moving device; and the illumination condition information of the working area comprises the current illumination intensity information, and the control module formulates or adjusts the working plan based on the current illumination intensity information.
33. The automatic working system according to clause 28, wherein the control module formulates or adjusts the working plan of the self-moving device according to a relationship between illumination intensity corresponding to the illumination condition information and a preset illumination intensity threshold.
34. The automatic working system according to clause 33, wherein the working plan comprises enabling the self-moving device to enter a working mode, and in the working mode, the control module controls the self-moving device to move and work.
35. The automatic working system according to clause 34, wherein when illumination intensity corresponding to the illumination condition information is less than or equal to a first illumination intensity threshold, and when a voltage of the energy storage unit is greater than a first threshold voltage, the control module controls the self-moving device to enter the working mode.
36. The automatic working system according to clause 35, wherein when the illumination intensity corresponding to the illumination condition information is greater than the first illumination intensity threshold, and when the voltage of the energy storage unit is greater than or equal to a second threshold voltage, the control module controls the self-moving device to enter the working mode, wherein the second threshold voltage is greater than the first threshold voltage.
37. The automatic working system according to clause 28, wherein when a voltage of the energy storage unit is less than or equal to a first threshold voltage, the self-moving device stops working; and the control module adjusts a value of the first threshold voltage based on the illumination condition information of the working area.
38. The automatic working system according to clause 37, wherein the self-moving device comprises a storage unit, configured to store a season model parameter, and the season model parameter comprises illumination condition information of different regions and different time periods; and the control module receives a geographic location and date information, and obtains the season model parameter based on the received geographic location and date information, so as to determine illumination condition information of the working area in a current time period.
39. The automatic working system according to clause 37, wherein a value of the first threshold voltage is increased as a time period in which illumination intensity reflected by the illumination condition information is maintained to be less than or equal to a first illumination intensity threshold is increased.
40. The automatic working system according to clause 1, wherein the self-moving device comprises a storage unit, configured to store a preset path mode, and the control module controls the self-moving device to move in the preset path mode.
41. The automatic working system according to clause 40, wherein a ratio of an area of a preset working area to an area of an area through which the self-moving device passes to complete coverage of the working area is referred as an effective coverage ratio of the self-moving device in the preset path mode; and the effective coverage ratio of the self-moving device in the preset path mode is greater than or equal to 0.6.
42. The automatic working system according to clause 1, wherein the self-moving device comprises a temperature control device, configured to reduce a temperature of a periphery of the energy storage unit.
43. The automatic working system according to clause 42, wherein the temperature control device comprises a container, configured to hold a cooling solvent and disposed in the periphery of the energy storage unit, to absorb heat of the energy storage unit; or the temperature control device comprises a fan, configured to form an airflow flowing from the energy storage unit to the outside of the housing; or the temperature control device comprises a heat insulation component, disposed in the periphery of the energy storage unit to insulate heat of the energy storage unit.
44. The automatic working system according to clause 1, wherein the self-moving device comprises a charging panel for mounting the photoelectric conversion unit, disposed on the housing; and the control module generates or receives a cleaning request signal of the charging panel and generates a cleaning warning signal in response to the cleaning request signal.
45. The automatic working system according to clause 44, wherein the self-moving device comprises a timer, a cleaning cycle is preset, and the timer starts timing from completion of cleaning of the charging panel last time and sends the cleaning request signal to the control module when the cleaning cycle expires.
46. The automatic working system according to clause 44, wherein the control module determines whether the effective working electric energy received by the energy consumption device from the photoelectric conversion unit decreases, and generates a cleaning request signal if the effective working electric energy decreases and reaches a threshold.
47. The automatic working system according to clause 44, wherein the cleaning warning signal comprises an optical signal, a sound signal, or prompt information sent to a user terminal.
48. An automatic working system, comprising a self-moving device, configured to move and work in a working area, wherein:
   the self-moving device comprises a housing, a moving module, and a control module, and the control module controls the moving module to actuate the self-moving device to move;
   the self-moving device further comprises a charging apparatus, and the charging apparatus comprises a photoelectric conversion unit, configured to receive optical energy, and convert the received optical energy into electric energy; and
   the self-moving device further comprises an energy storage unit, configured to store the electric energy obtained by conversion by the photoelectric conversion unit and provide energy for moving and working of the self-moving device, wherein
   the electric energy obtained by conversion by the photoelectric conversion unit is a unique energy source of the energy storage unit.
49. An automatic working system, comprising:
   a self-moving device, configured to move and work in a working area and comprising a housing, a moving module, and a control module, wherein the control module controls the moving module to actuate the self-moving device to move; and
   a charging apparatus, configured to provide energy for moving and working of the self-moving device, wherein
   when the automatic working system works, the charging apparatus is at least partially located in the working area, and the charging apparatus that is located in the working area is only mounted on the housing of the self-moving device; and
   the charging apparatus comprises a photoelectric conversion unit, wherein the photoelectric conversion unit receives optical energy and converts the received optical energy into electric energy.
50. An automatic working system, comprising:
   a self-moving device, configured to move and work in a working area and comprising a housing, a moving module, and a control module, wherein the control module controls the moving module to actuate the self-moving device to move; and
   an energy conversion unit, configured to convert external energy into internally stored energy of the self-moving device, wherein the energy conversion unit only comprises a photoelectric conversion unit, and is located on the self-moving device.

## Claims

1. An automatic working system (100), comprising a self-moving device, configured to move and work in a working area, wherein:
the self-moving device comprises a housing (3), a moving module, and a control moduleto control the moving module to actuate the self-moving device to move;
the self-moving device comprises an energy consumption device, wherein the energy consumption device comprises a device that consumes energy for actuating the self-moving device to move and work; and
the self-moving device further comprises:
a photoelectric conversion unit (11), wherein the photoelectric conversion unit (11) receives optical energy and converts the received optical energy into electric energy; and
an energy storage unit, configured to store the electric energy obtained by conversion by the photoelectric conversion unit (11),
wherein the self-moving device is configured to operate when effective working electric energy that is received by the energy consumption device from the photoelectric conversion unit (11) and that is converted by the photoelectric conversion unit (11) is greater than or equal to energy consumed by the energy consumption device to actuate the self-moving device to move and work;
wherein the control module is configured to receive illumination condition information of the working area, formulate or adjust a working plan of the self-moving device based on the illumination condition information of the working area, and control the self-moving device to carry out the working plan.

2. The automatic working system according to claim 1, wherein the self-moving device comprises a communications module, configured to obtain weather information through the Internet; and the illumination condition information of the working area comprises the weather information, and the control module is configured to formulate or adjust the working plan based on the weather information.

3. The automatic working system according to claim 2, wherein the weather information comprises total low cloud amount information or illumination intensity information.

4. The automatic working system according to claim 1, wherein the self-moving device comprises a clock module, configured to output a current moment; and the illumination condition information of the working area comprises time period information in one day, and the control module formulates or adjusts the working plan based on time period information of the current moment.

5. The automatic working system according to claim 1, wherein the self-moving device comprises an illumination sensor, configured to output illumination intensity information currently received by the self-moving device; and the illumination condition information of the working area comprises the current illumination intensity information, and the control module formulates or adjusts the working plan based on the current illumination intensity information.

6. The automatic working system according to claim 1, wherein the control module formulates or adjusts the working plan of the self-moving device according to a relationship between illumination intensity corresponding to the illumination condition information and a preset illumination intensity threshold.

7. The automatic working system according to claim6, wherein the working plan comprises enabling the self-moving device to enter a working mode, and in the working mode, the control module controls the self-moving device to move and work.

8. The automatic working system according to claim 7, wherein when illumination intensity corresponding to the illumination condition information is less than or equal to a first illumination intensity threshold, and when a voltage of the energy storage unit is greater than a first threshold voltage, the control module controls the self-moving device to enter the working mode.

9. The automatic working system according to claim 8, wherein when the illumination intensity corresponding to the illumination condition information is greater than the first illumination intensity threshold, and when the voltage of the energy storage unit is greater than or equal to a second threshold voltage, the control module controls the self-moving device to enter the working mode, wherein the second threshold voltage is greater than the first threshold voltage.

10. The automatic working system according to claim 1, wherein when a voltage of the energy storage unit is less than or equal to a first threshold voltage, the self-moving device stops working; and the control module adjusts a value of the first threshold voltage based on the illumination condition information of the working area.

11. The automatic working system according to claim 10, wherein the self-moving device comprises a storage unit, configured to store a season model parameter, and the season model parameter comprises illumination condition information of different regions and different time periods; and the control module receives a geographic location and date information, and obtains the season model parameter based on the received geographic location and date information, so as to determine illumination condition information of the working area in a current time period.

12. The automatic working system according to claim 10, wherein a value of the first threshold voltage is increased as a time period in which illumination intensity reflected by the illumination condition information is maintained to be less than or equal to a first illumination intensity threshold is increased.

13. The automatic working system according to any one of claims 1-12, wherein the self-moving device is an automatic mower, preferably wherein the automatic mower is controlled to work in the night time or a working plan of the automatic mower at midday is adjusted.

14. The automatic working system according to any one of claims 1-13, wherein an output voltage of the photoelectric conversion unit is used as a parameter for measuring illumination intensity.

15. The automatic working system according to any one of claims 13-14, wherein the illumination condition information of the working area includes weather information, wherein the control module formulates or adjusts a working plan based on the weather information such that the automatic mower is controlled not to work on a rainy day.
